# EUROPÄISCHE PATENTSCHRIFT

(11) **EP 3 084 917 B1**
(45) Veröffentlichungstag und Bekanntmachung des Hinweises auf die Patenterteilung: **24.04.2019**
(21) Anmeldenummer: 14802930.9
(22) Anmeldetag: 27.11.2014
(51) Int. Cl.: H02J 50/10, H02J 50/70, H02J 7/00, H02J 7/02

(54) **INDUKTIONSLADEVORRICHTUNG**
INDUCTIVE CHARGING DEVICE
DISPOSITIF DE CHARGE PAR INDUCTION

(30) Priorität: 17.12.2013 DE 102013226234; 17.03.2014 DE 102014204919; 29.08.2014 DE 102014217272
(43) Veröffentlichungstag der Anmeldung: 26.10.2016
(73) Patentinhaber: Robert Bosch GmbH, 70442 Stuttgart (DE)
(72) Erfinder: REJMAN, Marcin, 71334 Waiblingen (DE); GONDA, Martin, 77815 Buehl (DE); LOHR, Guenter, 70771 Leinfelden-Echterdingen (DE); MACK, Juergen, 73035 Goeppingen (DE); KRUPEZEVIC, Dragan, 70565 Stuttgart (DE)
(86) Internationale Anmeldenummer: PCT/EP2014/075871
(87) Internationale Veröffentlichungsnummer: WO 2015/090899

(56) Entgegenhaltungen:
- DE-A1-102011 003 516
- DE-A1-102012 203 485
- DE-U1- 9 411 279
- US-A1- 2011 241 617
- US-A1- 2013 193 915

## Beschreibung

### Stand der Technik

Es ist bereits eine Induktionsladevorrichtung mit einem Gehäuse und einer Spuleneinheit, umfassend zumindest ein Kernelement und zumindest eine Induktionsspule, vorgeschlagen worden.

Die US 2013/0193915 A1 und die US 2011/0241617 A1 zeigen induktive Ladegeräte.

### Offenbarung der Erfindung

Die Erfindung bezieht sich auf eine Induktionsladevorrichtung, wie im unabhängigen Anspruch 1 gefordert.

Unter einer "Induktionsladevorrichtung" soll in diesem Zusammenhang insbesondere eine Einheit zur Aufladung des zumindest einen Induktionsakkumulators verstanden werden, die dazu vorgesehen ist, in zumindest einem Ladezustand einen Ladestrom zumindest teilweise durch elektromagnetische Induktion an den Induktionsakkumulator weiterzugeben. Unter einer "Spuleneinheit" soll in diesem Zusammenhang insbesondere eine Einheit verstanden werden, die die zumindest eine Induktionsspule mit zumindest einer Wicklung aus einem elektrisch leitenden Material aufweist, die dazu vorgesehen ist, in zumindest einem Ladezustand durch eine anliegende elektrische Energie, insbesondere durch eine Wechselspannung, ein Magnetfeld zu erzeugen, das in einer Induktionsspule des Induktionsakkumulators einen elektrischen Wechselstrom erzeugt.

Insbesondere ist die Spuleneinheit, vorzugsweise die Induktionsspule, dazu vorgesehen, ein elektromagnetisches Wechselfeld in einen elektrischen Wechselstrom umzuwandeln und/oder umgekehrt. Bevorzugt weist das Wechselfeld eine Frequenz von 10 - 500 kHz, besonders bevorzugt von 100 - 120 kHz, auf. Insbesondere ist die Richtung senkrecht zu der Spulenebene parallel zu einer Wicklungsachse der Induktionsspule ausgebildet. Bevorzugt umfasst die Spuleneinheit zudem das zumindest eine Kernelement zu einer Erhöhung einer Induktivität der zumindest einen Induktionsspule.

Die Induktionsspule kann eine im Wesentlichen kreisförmige Grundform haben. Alternativ kann die Grundform auch nicht kreisförmig sein. Sie kann zum Beispiel oval, rechteckig oder quadratisch sein. Bei einer rechteckigen oder quadratischen Grundform können die Ecken abgerundet sein.

Unter "vorgesehen" soll insbesondere speziell ausgestaltet, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Unter einem "Induktionsakkumulator" soll in diesem Zusammenhang insbesondere eine Vorrichtung verstanden werden, die vorzugsweise eine wiederaufladbare Energiespeichereinheit umfasst, die zumindest teilweise dazu vorgesehen ist, eine Energie zu einer Erzeugung eines elektrischen Stroms elektrochemisch mittels einer reversiblen Reaktion zu speichern und durch Einleitung eines Ladestroms aufzuladen, und die dazu vorgesehen ist, eine elektrische Maschine, insbesondere eine Handwerkzeugmaschine, mit Strom zu versorgen. Bevorzugt weist der Induktionsakkumulator eine Schnittstelleneinheit auf, welche dazu ausgebildet ist, den Induktionsakkumulator mit einer Handwerkzeugmaschine lösbar mechanisch und elektrisch zu koppeln. Der Induktionsakkumulator umfasst eine oder mehrere Akkuzellen. Der Induktionsakkumulator kann zumindest eine NiCd- oder NiMh- Akkuzelle aufweisen. Vorzugsweise weist der Induktionsakkumulator zumindest eine lithiumbasierte Akkuzelle auf. Andere Akkuzellentechnologien können ebenfalls zum Einsatz kommen. Unter einer "Handwerkzeugmaschine" soll in diesem Zusammenhang insbesondere ein durch einen Benutzer handgeführtes Elektrogerät, wie insbesondere eine Bohrmaschine, ein Bohrhammer, eine Säge, ein Hobel, ein Schrauber, eine Fräse, ein Schleifer, ein Winkelschleifer und/oder ein Multifunktionswerkzeug oder ein Gartengerät wie eine Hecken-, Strauch- und/oder Grasschere oder eine andere, einem Fachmann als sinnvoll erscheinende Ausgestaltung des Elektrogeräts verstanden werden.

Unter "zumindest teilweise umschließen" soll in diesem Zusammenhang insbesondere verstanden werden, dass die Induktionsspule das zumindest eine Kernelement auf zumindest einer Ebene über einen Winkelbereich von mehr als 180 °, vorzugsweise mehr als 270° und besonders bevorzugt von 360° umgibt.

Durch die erfindungsgemäße Ausgestaltung der Induktionsladevorrichtung können auf konstruktiv einfache Weise eine bevorzugt hoher Wirkungsgrad und eine vorteilhaft hohe Effektivität erreicht werden.

Es wird vorgeschlagen, dass das Spulengehäuseelement zumindest eine Ausnehmung zur Aufnahme der zumindest einen Induktionsspule aufweist. Die Ausnehmung ist insbesondere nutförmig ausgebildet. Die Induktionsspule ist insbesondere durch Wickeln in die Ausnehmung eingebracht. Das Spulengehäuseelement dient so als Spulenträger für die Induktionsspule.

Ferner wird vorgeschlagen, dass das Spulengehäuseelement zumindest einen Aufnahmebereich zur Aufnahme des zumindest einen Kernelements aufweist. In einer bevorzugten Ausführungsform weist die Spuleneinheit mehrere, insbesondere formgleiche, Kernelemente auf. Das Spulengehäuseelement weist insbesondere eine der Anzahl der Kernelemente entsprechende Anzahl an Aufnahmebereichen auf. Für jedes Kernelement weist das Spulengehäuseelement einen Aufnahmebereich auf, so dass jedes Kernelement in einem separaten Aufnahmebereich in dem Spulengehäuseelement aufgenommen ist. Die Kernelemente bilden zusammen eine Kerneinheit.

Das Spulengehäuseelement weist insbesondere zumindest ein Halteelement zur lösbaren Befestigung mit dem Gehäuse der Induktionsladevorrichtung auf. Das Halteelement ist zum Beispiel als Haltelasche ausgeführt. Mit Hilfe der Haltelasche kann das Spulengehäuseelement zum Beispiel mit dem Gehäuse der Induktionsladevorrichtung verschraubt sein. Alternative Ausführungen einer lösbaren Befestigung, mit der das Spulengehäuseelement formschlüssig und/oder kraftschlüssig mit dem Gehäuse der Induktionsladevorrichtung koppelbar ist, sind ebenfalls möglich.

Es wird des Weiteren vorgeschlagen, dass die Induktionsladevorrichtung ein zweites Spulengehäuseelement aufweist, welches mit dem ersten Spulengehäuseelement eine Spulengehäuseeinheit bildet. Die Spulengehäuseeinheit nimmt zumindest die Spuleneinheit auf. Die Spulengehäuseeinheit und die Spuleneinheit bilden so eine Baugruppe, welche zunächst unabhängig von dem Gehäuse der Induktionsladevorrichtung zusammengebaut werden kann, bevor sie in das Gehäuse eingebaut wird. Das zweite Spulengehäuseelement kann alternativ oder zusätzlich zu dem zumindest einen Halteelement des ersten Spulengehäuseelements zumindest ein Halteelement zur lösbaren Befestigung mit dem Gehäuse der Induktionsladevorrichtung aufweisen.

In einer vorteilhaften Ausgestaltung umfasst die Spulengehäuseeinheit zumindest ein Verbindungselement, welches die zwei Spulengehäuseelemente in einem montierten Zustand lösbar miteinander verbindet. Das Verbindungselement kann insbesondere als Rastelement ausgebildet sein. Unter einem "Rastelement" soll in diesem Zusammenhang insbesondere ein federelastisches Mittel zur Herstellung einer Rastverbindung verstanden werden, das dazu vorgesehen ist, bei einer Montage elastisch ausgelenkt zu werden. Dadurch kann eine vorteilhaft einfache und zuverlässige Kopplung der zumindest zwei Spulengehäuseelemente der Spulengehäuseeinheit erreicht werden.

Insbesondere ist die Spulengehäuseeinheit in dem Gehäuse lösbar befestigt. Beispielswiese kann die Spulengehäuseeinheit mit Hilfe des Halteelements des ersten Spulengehäuseelements mit dem Gehäuse lösbar befestigt, z.B. verschraubt, sein. Dadurch kann eine vorteilhaft sichere und konstruktiv einfache Verbindung zwischen der Spulengehäuseeinheit und dem Gehäuse erreicht werden.

Es wird vorgeschlagen, dass die Induktionsladevorrichtung zumindest ein Federelement umfasst, das zumindest teilweise dazu vorgesehen ist, das zumindest eine Kernelement zumindest teilweise zu der zumindest einen Induktionsspule hin mit einer Kraft zu beaufschlagen.

Unter einem "Federelement" soll in diesem Zusammenhang insbesondere ein makroskopisches Element verstanden werden, das zumindest eine Erstreckung, insbesondere eine Haupterstreckung, aufweist, die in einem normalen Betriebszustand um zumindest 1 %, insbesondere um wenigstens 2 %, vorzugsweise um mindestens 5 % und besonders vorteilhaft um zumindest 10 %, insbesondere elastisch, veränderbar ist, und das insbesondere eine von einer Veränderung der Erstreckung abhängige und vorzugsweise zu der Veränderung proportionale Gegenkraft erzeugt, die der Veränderung entgegenwirkt. Unter einem "makroskopischen Element" soll insbesondere ein Element mit einer Erstreckung von zumindest 1 mm, insbesondere von wenigstens 5 mm und vorzugsweise von mindestens 10 mm verstanden werden. Unter einer "Haupterstreckung" eines Elements soll insbesondere eine Länge entlang einer längsten Mittelfaser, insbesondere entlang einer längsten Außenkante, des Federelements verstanden werden.

Ferner wird vorgeschlagen, dass das zumindest eine Federelement eine Kraft in Richtung eines Aufnahmebereichs zu einer Aufnahme des Induktionsakkumulators auf das zumindest eine Kernelement bewirkt. In einem gekoppelten Zustand des Induktionsackumulators mit der Induktionsladevorrichtung ist der Induktionsakkumulator in dem Aufnahmebereich in zumindest eine Raumrichtung, vorzugsweise in zumindest zwei Raumrichtungen, formschlüssig und/oder kraftschlüssig gehalten. Dadurch kann ein vorteilhaft geringer Abstand zwischen der zumindest einen Induktionsspule und dem zumindest einen Kernelement und dadurch ein bevorzugt hoher Wirkungsgrad erreicht werden.

Es ist vorgesehen, dass das zumindest eine Federelement und zumindest eines der zumindest zwei Spulengehäuseelemente derart zusammenwirken, dass das zumindest eine Kernelement zu der zumindest einen Induktionsspule hin vorgespannt ist. Insbesondere weist zumindest eines der zumindest zwei Spulengehäuseelemente das zumindest eine Federelement auf. Ferner ist das zumindest eine Federelement insbesondere fest mit zumindest einem der Spulengehäuseelemente verbunden. Das zumindest eine Federelement ist mit zumindest einem der Spulengehäuseelemente insbesondere einstückig ausgebildet.

Zudem wird vorgeschlagen, dass die Induktionsladevorrichtung eine Spulengehäuseeinheit aufweist, die die Spuleneinheit zumindest teilweise umschließt und die das zumindest eine Federelement aufweist. Unter "zumindest teilweise umschließen" soll in diesem Zusammenhang insbesondere verstanden werden, dass die Spulengehäuseeinheit zumindest die Spuleneinheit in zumindest einer Ebene, vorzugsweise in zumindest zwei, insbesondere senkrecht zueinander stehenden, Ebenen und besonders bevorzugt in drei, insbesondere senkrecht zueinander stehenden, Ebenen über einen Winkelbereich von mehr als 180°, vorzugsweise mehr als 270 °und besonders bevorzugt von 360° die Induktionsladeeinheit umgibt. Vorzugsweise überdeckt die Spulengehäuseeinheit insbesondere zumindest 40 %, vorzugsweise zumindest 50 %, bevorzugt zumindest 60 % und besonders bevorzugt zumindest 70 % einer Oberfläche der Spuleneinheit. Dadurch kann eine bevorzugt robuste und vorteilhaft modulare Ausgestaltung der Induktionsladevorrichtung erreicht werden.

Des Weiteren wird vorgeschlagen, dass das zumindest eine Federelement fest mit der Spulengehäuseeinheit verbunden ist. Unter "fest verbunden" soll in diesem Zusammenhang insbesondere verstanden werden, dass das zumindest eine Federelement und die Spulengehäuseeinheit nicht zerstörungsfrei trennbar miteinander verbunden sind. Dadurch kann eine bevorzugt kompakte Ausgestaltung der Induktionsladevorrichtung erreicht werden.

Ferner wird vorgeschlagen, dass das zumindest eine Federelement einstückig mit der Spulengehäuseeinheit ausgebildet ist. Unter "einstückig" soll in diesem Zusammenhang insbesondere zumindest stoffschlüssig verbunden verstanden werden, beispielsweise durch einen Schweißprozess, einen Klebeprozess, einen Anspritzprozess und/oder einen anderen, dem Fachmann als sinnvoll erscheinenden Prozess, und/oder vorteilhaft in einem Stück geformt verstanden werden, wie beispielsweise durch eine Herstellung aus einem Guss und/oder durch eine Herstellung in einem Ein- oder Mehrkomponentenspritzverfahren und vorteilhaft aus einem einzelnen Rohling. Dadurch kann eine bevorzugt kompakte und bauteilsparende Ausgestaltung der Induktionsladevorrichtung erreicht werden.

Zudem wird vorgeschlagen, dass die zumindest eine Induktionsspule zumindest zwei Spulenanschlüsse umfasst, die beabstandet zueinander angeordnet sind. Unter einem "Spulenanschluss" soll in diesem Zusammenhang insbesondere ein Element verstanden werden, das dazu vorgesehen ist, die zumindest eine Induktionsspule elektrisch mit einer Stromquelle und/oder mit einer Speichereinheit, wie beispielsweise mit zumindest einer Batterie, vorzugsweise direkt, zu verbinden. Unter "beabstandet" soll in diesem Zusammenhang insbesondere verstanden werden, dass ein geringster Abstand zwischen den zumindest zwei Spulenanschlüssen insbesondere zumindest 5 mm, vorzugsweise zumindest 10 mm, bevorzugt zumindest 20 mm und besonders bevorzugt zumindest 30 mm beträgt. Dadurch kann eine vorteilhaft hohe elektrische Isolation, insbesondere von bis zu 1500 Volt, erreicht werden.

Ferner wird vorgeschlagen, dass das zumindest eine Federelement und zumindest eines der zumindest zwei Spulengehäuseelemente dazu vorgesehen sind, das zumindest eine Kernelement in einem montierten Zustand einzuspannen. Dabei wirken das zumindest eine Federelement und zumindest eines der zumindest zwei Spulengehäuseelemente derart zusammen, dass das zumindest eine Kernelement zu der zumindest einen Induktionsspule hin vorgespannt ist. Dadurch kann ein bevorzugt hoher Wirkungsgrad, eine vorteilhaft hohe Effektivität und eine konstruktiv einfache Fixierung der Kernelemente in einem Ladezustand erreicht werden.

Des Weiteren wird vorgeschlagen, dass die Spuleneinheit mehrere, insbesondere formgleiche, Kernelemente aufweist und mehrere, insbesondere formgleiche, Federelemente vorgesehen sind, welche jeweils eines der Kernelemente zumindest teilweise zu der zumindest einen Induktionsspule hin mit einer Kraft zu beaufschlagen. Dadurch kann ein bevorzugt hoher Wirkungsgrad und eine vorteilhaft hohe Effektivität in einem Ladezustand erreicht werden.

Es wird ferner vorgeschlagen, dass die Induktionsladevorrichtung ein Abschirmelement aufweist, welches dazu ausgebildet ist, elektromagnetische Störungen zu verringern. Das Abschirmelement ist insbesondere dazu ausgebildet, mit der Induktionsspule der Induktionsladevorrichtung einen Bypass-Kondensator zu bilden. Dabei bildet die Induktionsspule eine erste Elektrode des Bypass-Kondensators und das Abschirmelement eine zweite Elektrode des Bypass-Kondensators. Das Abschirmelement umfasst zumindest ein elektrisch leitfähiges Element, welches eine elektrisch leitfähige Schicht bildet. Das elektrisch leitfähige Element ist insbesondere aus einem nicht metallischen Werkstoff und insbesondere aus einem nicht ferromagnetischen Werkstoff gebildet. Das elektrisch leitfähige Element ist vorzugsweise als Flächengebilde, zum Beispiel als Gewebe, Gewirke, Geflecht oder dergleichen, aus Kohlenstofffasern ausgebildet. Das Abschirmelement umfasst ferner zumindest zwei Isolierelemente, welche Isolierschichten bilden. Das elektrisch leitfähige Element ist zwischen den beiden Isolierelementen angeordnet. Ein im Wesentlichen umlaufender Randbereich des Abschirmelements ist frei von elektrisch leitfähigem Material des elektrisch leitfähigen Elements. In diesem Randbereich sind die beiden Isolierelemente direkt aneinander anliegend angeordnet, ohne dass elektrisch leitfähiges Material des elektrisch leitfähigen Elements dazwischen liegt. Das Abschirmelement umfasst ferner ein elektrisch leitfähiges Kontaktelement zur elektrischen Kontaktierung des Abschirmelements. Das Abschirmelement ist über das elektrisch leitfähige Kontaktelement insbesondere mit einer Masse verbunden.

Das Abschirmelement ist insbesondere zwischen dem Aufnahmebereich der Induktionsladevorrichtung und der Induktionsspule angeordnet. Dabei ist das Abschirmelement derart relativ zu der Induktionsspule angeordnet, dass während eines Ladevorgangs des Induktionsakkumulators mit der Induktionsladevorrichtung das Abschirmelement zwischen der Induktionsspule der Induktionsladevorrichtung und der Induktionsspule des Induktionsakkumulators angeordnet ist. Das Abschirmelement ist ganz insbesondere zwischen dem Aufnahmebereich und der Spuleneinheit angeordnet. Das Abschirmelement ist ferner insbesondere zwischen dem Aufnahmebereich und der Induktionsladeeinheit angeordnet. Das Abschirmelement ist ferner insbesondere zwischen dem Aufnahmebereich und der Spulengehäuseeinheit angeordnet. Das Abschirmelement ist ferner insbesondere zwischen dem Aufnahmebereich und dem dem Aufnahmebereich zugewandten Spulengehäuseelement angeordnet. Bei der Anordnung des Abschirmelements zwischen dem Aufnahmebereich und der Induktionsspule ist ein möglichst geringer Abstand zwischen dem Abschirmelement und der Induktionsspule von Vorteil.

In einer vorteilhaften Ausgestaltung hat das Abschirmelement eine Ausdehnung in der Fläche, die mindestens der Ausdehnung der von der Induktionsspule gebildeten Fläche entspricht. Die von dem Abschirmelement gebildete Fläche ist demnach mindestens so groß wie die von der Induktionsspule gebildete Fläche. Das Abschirmelement ist insbesondere im Wesentlichen vollflächig ausgebildet. Bei einer Anordnung des Abschirmelements zwischen Aufnahmebereich und Induktionsspule bedeckt das Abschirmelement damit die Induktionsspule im Wesentlichen vollständig.

Die Grundform des Abschirmelements kann der Grundform der Induktionsspule angepasst sein. Bei einer im Wesentlichen kreisförmigen Induktionsspule hat das Abschirmelement vorzugsweise eine im Wesentlichen runde Grundform ausgebildet. Bei einer nicht kreisförmigen Induktionsspule, die zum Beispiel oval, rechteckig oder quadratisch ausgebildet ist, ist das Abschirmelement vorzugsweise ebenfalls nicht rund, zum Beispiel oval, rechteckig oder quadratisch ausgebildet.

In einer weitergehenden Ausgestaltung umfasst das Abschirmelement ein Bodenelement und zumindest ein Wandelement, welches an dem Bodenelement angeordnet ist. Dabei bildet das Bodenelement eine Grundfläche, deren Ausdehnung mindestens der Ausdehnung der von der Induktionsspule gebildeten Fläche entspricht. Die von dem Bodenelement gebildete Grundfläche ist demnach mindestens so groß wie die von der Induktionsspule gebildete Fläche. Zumindest in der Einbaulage des Abschirmelements in der Induktionsladevorrichtung ist das Wandelement zu dem Bodenelement geneigt, insbesondere im Wesentlichen in einem Winkel von 90° geneigt angeordnet. In der Einbaulage steht das Wandelement im Wesentlichen senkrecht von dem Bodenelement ab. Das zumindest eine Wandelement bildet eine Umfangswand des Abschirmelements, welche die Induktionsspule an ihrem Außenumfang im Wesentlichen vollständig umschließt. Die Umfangswand des Abschirmelements kann auch aus mehreren Wandelementen gebildet sein.

Es wird ferner vorgeschlagen, dass die Induktionsladevorrichtung ein weiteres Abschirmelement aufweist, welches dazu ausgebildet ist, elektromagnetische Störungen zu verringern. Das Abschirmelement ist insbesondere dazu ausgebildet, die Induktionsspule während eines Ladevorgangs eines Induktionsakkumulators gegenüber metallischen Objekten abzuschirmen, die sich auf einer Standfläche für die Induktionsladevorrichtung, zum Beispiel einer Tischfläche, befinden. Eine Standfläche aus einem metallischen Werkstoff oder metallische Partikel auf der Standfläche beeinflussen die Funktion der Induktionsspule in unvorteilhafter Weise. Um die Abschirmung der Induktionsspule gegenüber metallischen Objekten auf einer Standfläche für die Induktionsladevorrichtung zu erreichen, ist das Abschirmelement insbesondere zwischen einem Gehäuseelement des Gehäuses der Induktionsladevorrichtung und der Induktionsspule angeordnet. Dabei ist das Abschirmelement einer Seite der Induktionsspule zugewandt, die von dem Aufnahmebereich abgewandt ist. Das Abschirmelement ist demnach auf einer Seite der Induktionsspule angeordnet, die einer Standfläche des Gehäuses der Induktionsladevorrichtung zugewandt ist. Dieses Abschirmelement kann alternativ oder zusätzlich zu dem oben beschriebenen Abschirmelement, welches zwischen der Induktionsspule und dem Aufnahmebereich angeordnet ist, vorgesehen sein.

Das Abschirmelement ist insbesondere zwischen dem Gehäuseelement, das eine Standfläche der Induktionsladevorrichtung bildet, und der Induktionsladeeinheit angeordnet. Dabei ist das Abschirmelement außerhalb der Induktionsladeeinheit angeordnet. Das Abschirmelement ist zwischen der Spulengehäuseeinheit und dem eine Standfläche bildenden Gehäuseelement angeordnet. In einer alternativen Ausführungsform kann das Abschirmelement auch ein Element der Induktionsladeeinheit bilden, indem das Abschirmelement innerhalb der Induktionsladeeinheit angeordnet ist. Dabei kann das Abschirmelement in der Spulengehäuseeinheit angeordnet sein.

Das Abschirmelement ist aus einem elektrisch leitfähigen Material gebildet, wobei es vorteilhaft aus einem metallischen Material, zum Beispiel Aluminium, gebildet ist.

In einer Ausgestaltung ist das Abschirmelement im Wesentlichen ringförmig ausgebildet. In einer alternativen Ausgestaltung kann das Abschirmelement auch scheibenförmig ausgebildet sein, wobei das Abschirmelement insbesondere im Wesentlichen vollflächig ausgebildet sein kann. Die Grundform des Abschirmelements ist vorteilhafterweise an die Grundform der Induktionsspule angepasst. Zur Abschirmung einer im Wesentlichen kreisförmigen Induktionsspule, ist das Abschirmelement ebenfalls kreisförmig ausgebildet. Zur Abschirmung einer nicht kreisförmigen Induktionsspule, die zum Beispiel oval, rechteckig oder quadratisch ausgebildet ist, ist die geometrische Grundform des Abschirmelements an die Grundform der Induktionsspule angepasst und ebenfalls zum Beispiel oval, rechteckig oder quadratisch ausgebildet.

Des Weiteren ist vorteilhafterweise die Querschnittsfläche des Abschirmelements der Querschnittsfläche der Induktionsspule angepasst. Bevorzugt hat das Abschirmelement eine Ausdehnung in der Fläche, die mindestens der Ausdehnung der von der Induktionsspule gebildeten Fläche entspricht. Die von dem Abschirmelement gebildete Fläche ist demnach mindestens so groß wie die von der Induktionsspule gebildete Fläche. Zum Beispiel hat ein im Wesentlichen kreisförmiges Abschirmelement vorzugsweise einen Außendurchmesser, der mindestens so groß ist wie der Außendurchmesser der Induktionsspule. In analoger Weise ist bei einer nicht kreisförmigen Grundform eine Projektionsfläche des Abschirmelements, die bei einer Projektion des Abschirmelements entlang einer Axialrichtung der Induktionsladeeinheit gebildet wird, mindestens so groß wie die Projektionsfläche der Induktionsspule, die bei einer solchen Projektion der Induktionsspule entlang der Axialrichtung gebildet wird.

Zudem wird ein System mit einer erfindungsgemäßen Induktionsladevorrichtung und mit zumindest einem Induktionsakkumulator, insbesondere mit zumindest einem Handwerkzeuginduktionsakkumulator, vorgeschlagen.

Die erfindungsgemäße Induktionsladevorrichtung soll hierbei nicht auf die oben beschriebene Anwendung und Ausführungsform beschränkt sein. Insbesondere kann die erfindungsgemäße Induktionsladevorrichtung zu einer Erfüllung einer hierin beschriebenen Funktionsweise eine von einer hierin genannten Anzahl von einzelnen Elementen, Bauteilen und Einheiten abweichende Anzahl aufweisen.

### Zeichnung

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein System mit einer erfindungsgemäßen Induktionsladevorrichtung und mit einem Induktionsakkumulator in einer perspektivischen Darstellung,
- Fig. 2a: eine von einer Spulengehäuseeinheit umschlossene Spuleneinheit der erfindungsgemäßen Induktionsladevorrichtung in einer perspektivischen Darstellung in einer Draufsicht,
- Fig. 2b: die von der Spulengehäuseeinheit umschlossene Spuleneinheit der erfindungsgemäßen Induktionsladevorrichtung in einer perspektivischen Darstellung in einer Unteransicht,
- Fig. 3: ein Spulengehäuseelement der Spulengehäuseeinheit der erfindungsgemäßen Induktionsladevorrichtung in einer perspektivischen Ansicht und
- Fig. 4: die Spulengehäuseeinheit und die Spuleneinheit sowie die Kerneinheit der erfindungsgemäßen Induktionsladevorrichtung vor einem Zusammenbau der Komponenten in einer perspektivischen Darstellung in einer Draufsicht
- Fig. 5: die Spulengehäuseeinheit und die Kerneinheit der erfindungsgemäßen Induktionsladevorrichtung vor einem Zusammenbau der Komponenten in einer perspektivischen Darstellung in einer Unteransicht
- Fig. 6: die Spulengehäuseeinheit und die Spuleneinheit sowie die Kerneinheit der erfindungsgemäßen Induktionsladevorrichtung nach einem Zusammenbau der Komponenten im Querschnitt
- Fig. 7: die erfindungsgemäße Induktionsladevorrichtung vor einem Zusammenbau der Komponenten in einer perspektivischen Darstellung
- Fig. 8: die erfindungsgemäße Induktionsladevorrichtung vor einem Zusammenbau der Komponenten im Längsschnitt
- Fig. 9: ein Gehäuseelement der erfindungsgemäßen Induktionsladevorrichtung in einer perspektivischen Darstellung
- Fig. 10: das Gehäuseelement nach Fig. 9 mit einer Ausführungsform eines ersten Abschirmelements
- Fig. 11a: das erste Abschirmelement nach Fig. 10 in der Draufsicht
- Fig. 11b: das erste Abschirmelement nach Fig. 10 in einer Explosionsdarstellung
- Fig. 12: das Gehäuseelement nach Fig. 9 mit einer Induktionsladeeinheit und einer Ausführungsform eines zweiten Abschirmelements
- Fig. 13: die erfindungsgemäße Induktionsladevorrichtung vor einem Zusammenbau der Komponenten in einer perspektivischen Darstellung.

### Beschreibung des Ausführungsbeispiels

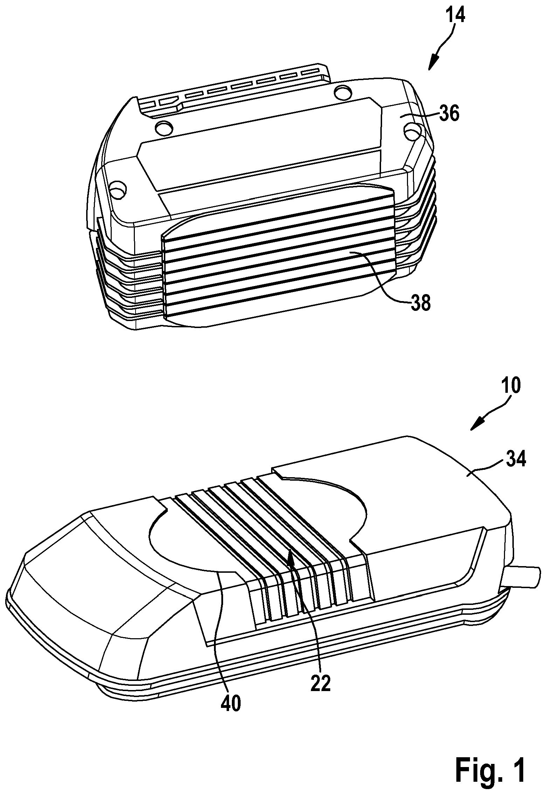

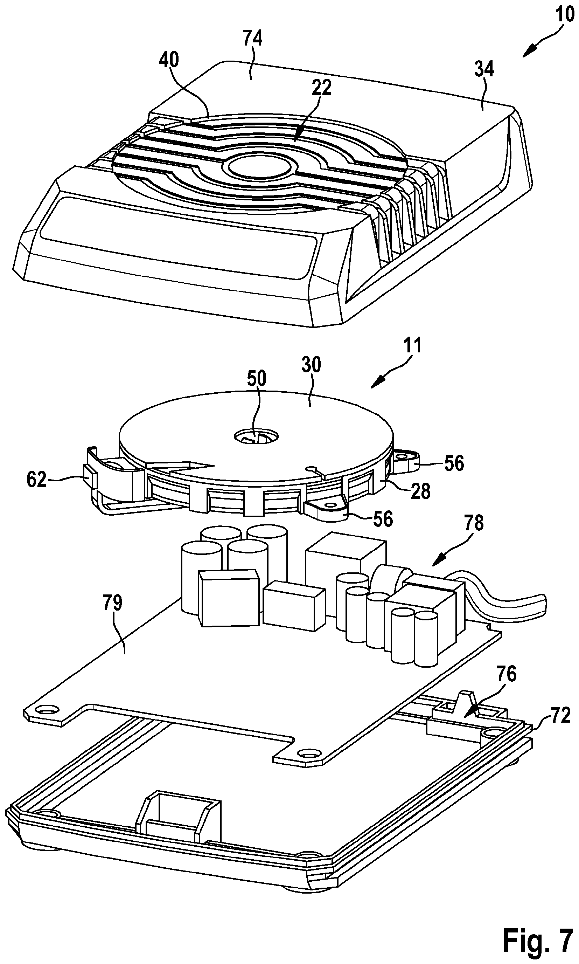

In Figur 1 ist ein System mit einer Induktionsladevorrichtung 10 und mit einem Induktionsakkumulator 14 dargestellt. Die Induktionsladevorrichtung 10 ist dazu vorgesehen, den Induktionsakkumulator 14 in einem Ladezustand elektrisch aufzuladen. Der Induktionsakkumulator 14 ist als Handwerkzeuginduktionsakkumulator ausgebildet. Der Induktionsakkumulator 14 ist mittels der Induktionsladevorrichtung 10 induktiv aufladbar ausgebildet. Der Induktionsakkumulator 14 ist mit der Induktionsladevorrichtung 10 koppelbar ausgebildet. Die Induktionsladevorrichtung 10 ist dazu vorgesehen, in einem mit dem Induktionsakkumulator 14 gekoppelten Zustand eine Energie auf den Induktionsakkumulator 14 zu übertragen. Hierfür weist der Induktionsakkumulator 14 eine nicht näher dargestellte Induktionsspule auf. Die Induktionsladevorrichtung 10 ist als Handwerkzeuginduktionsladevorrichtung ausgebildet. Die Induktionsladevorrichtung 10 ist als Induktionsladegerät ausgebildet. Die Induktionsladevorrichtung 10 weist ein Gehäuse 34 auf. Das Gehäuse 34 umschließt eine Induktionsladeeinheit 11. Die Induktionsladeeinheit 11 umfasst eine Spuleneinheit 12 und eine Spulengehäuseeinheit 24. Das Gehäuse 34 dient als Außengehäuse der Induktionsladevorrichtung 10. Die Spuleneinheit 12 ist zu einer induktiven Energieübertragung in einem Ladezustand auf den Induktionsakkumulator 14 vorgesehen. Die Induktionsladevorrichtung 10 umfasst ferner eine Elektronikeinheit 78, die dazu vorgesehen ist, einen Ladevorgang zu steuern oder zu regeln (Figur 7).

Das Gehäuse 34 der Induktionsladevorrichtung 10 weist einen Aufnahmebereich 22 auf, der zur Aufnahme des Induktionsakkumulators 14 in einem gekoppelten Zustand vorgesehen ist. Der Induktionsakkumulator 14 umfasst ebenfalls ein Gehäuse 36, das ein Positionierelement 38 zur Kopplung des Induktionsakkumulators 14 mit dem Aufnahmebereich 22 des Gehäuses 34 der Induktionsladevorrichtung 10 in einem gekoppelten Zustand aufweist. Das Positionierelement 38 des Induktionsakkumulators 14 ist als Podest, das sich über eine Außenfläche des angrenzenden Gehäuses 36 des Induktionsakkumulators 14 erhebt, ausgebildet. Der Aufnahmebereich 22 des Gehäuses 34 der Induktionsladevorrichtung 10 weist zumindest eine Vertiefung auf. Die Vertiefung bildet ein Positionierelement 40 zur Positionierung des Induktionsakkumulators 14. Es ist jedoch auch denkbar, dass das Positionierelement 40 der Induktionsladevorrichtung 10 als Podest und das Positionierelement 38 des Induktionsakkumulators 14 als Vertiefung ausgebildet sind. Die Vertiefung weist eine Absatzhöhe von zumindest 0,5 mm auf. Das Positionierelement 38 des Induktionsakkumulators 14 weist eine Absatzhöhe von zumindest 0,5 mm auf. Das Positionierelement 40 der Induktionsladevorrichtung 10 und das Positionierelement 38 des Induktionsakkumulators 14 sind korrespondierend ausgebildet.

Das Positionierelement 40 der Induktionsladevorrichtung 10 und das Positionierelement 38 des Induktionsakkumulators 14 weisen jeweils eine Absatzhöhe von 3 mm auf. Es sind jedoch auch andere, einem Fachmann als sinnvoll erscheinende Maße denkbar. Das Positionierelement 40 der Induktionsladevorrichtung 10 weist eine teilweise gekrümmte Außenkontur auf. Die Außenkontur des Positionierelements 40 der Induktionsladevorrichtung 10 ist rund ausgebildet. Das Positionierelement 38 des Induktionsakkumulators 14 weist eine teilweise gekrümmte Außenkontur auf. Die Außenkontur des Positionierelements 38 des Induktionsakkumulators 14 ist quadratisch mit abgerundeten Ecken ausgebildet. Ein Durchmesser des Positionierelements 40 der Induktionsladevorrichtung 10 entspricht zumindest nahezu einer Diagonallänge des Positionierelements 38 des Induktionsakkumulators 14. Zwischen den Abmessungen des Positionierelements 40 der Induktionsladevorrichtung 10 und des Positionierelements 38 des Induktionsakkumulators 14 ist eine geringe Toleranz vorgesehen. Alternativ ist es auch denkbar, dass die Außenkontur des Positionierelements 40 der Induktionsladevorrichtung 10 quadratisch mit abgerundeten Ecken und die Außenkontur des Positionierelements 38 des Induktionsakkumulators 14 rund ausgebildet ist. Ferner ist es auch denkbar, dass die Außenkontur des Positionierelements 40 der Induktionsladevorrichtung 10 oder des Positionierelements 38 des Induktionsakkumulators 14 eine andere, einem Fachmann als sinnvoll erscheinende geometrische Form, zum Beispiel eine rechteckige Form, insbesondere mit abgerundeten Ecken, aufweist. In einem Ladezustand liegt der Induktionsakkumulator 14 auf der Induktionsladevorrichtung 10, sodass das Positionierelement 38 des Induktionsakkumulators 14 in das Positionierelement 40 der Induktionsladevorrichtung 10 eingreift. Dabei kontaktiert das Gehäuse 36 des Induktionsakkumulators 14 das Gehäuse 34 der Induktionsladevorrichtung 10 direkt.

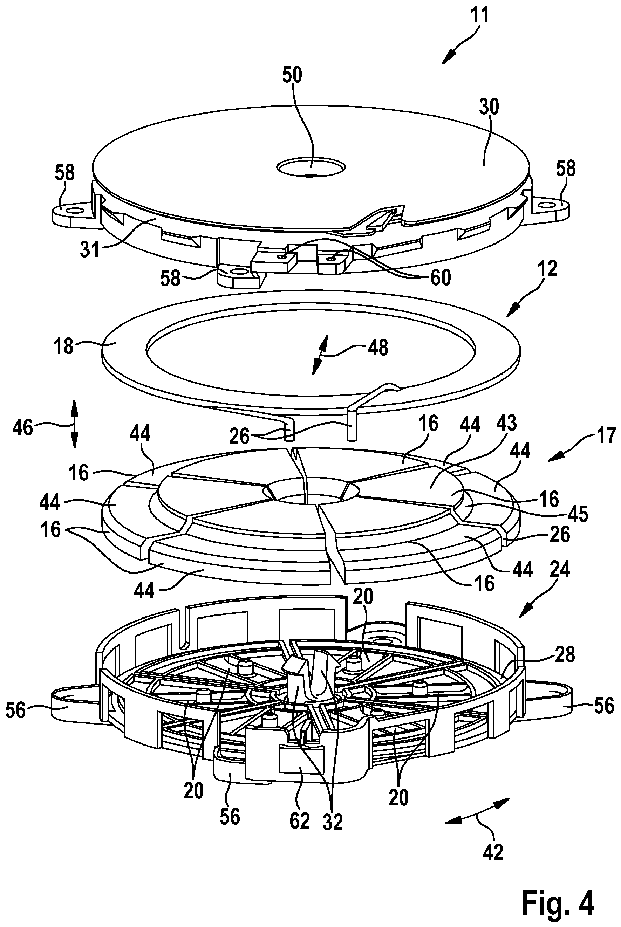

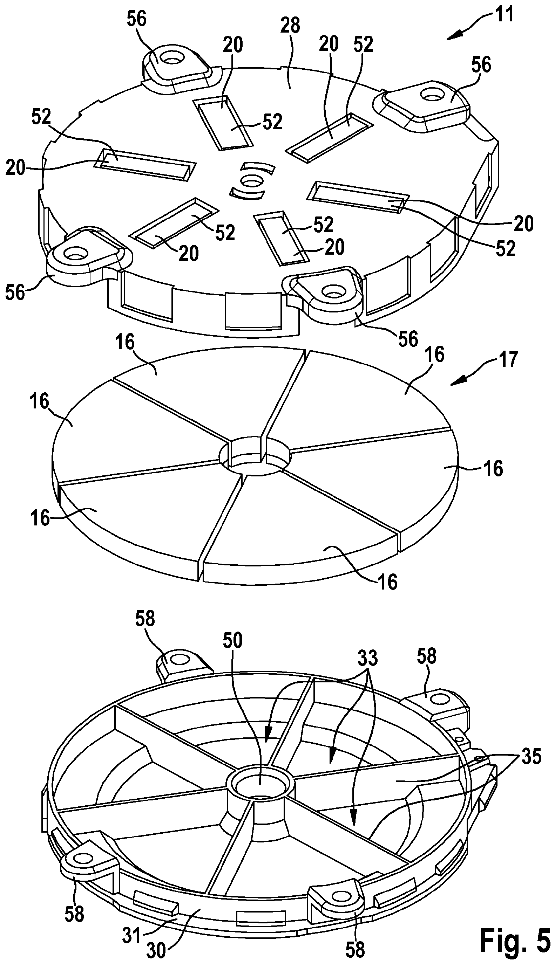

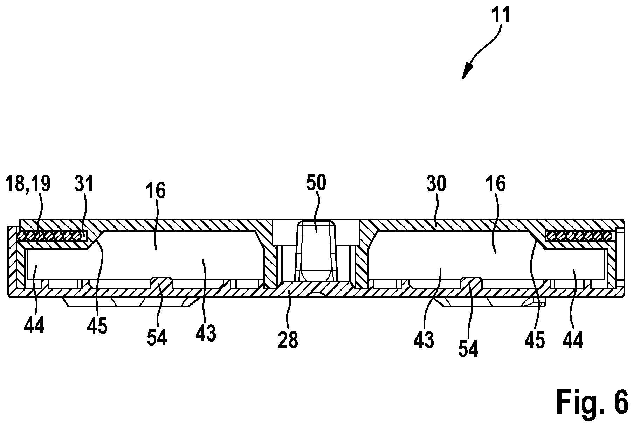

Die Induktionsladevorrichtung 10 weist die Spuleneinheit 12 auf, die dazu vorgesehen ist, in einem mit einem Induktionsakkumulator 14 gekoppelten Zustand eine Energie zu übertragen. Mittels der Spuleneinheit 12 wird in gekoppelten Zustand elektrische Energie von der Induktionsladevorrichtung 10 auf den Induktionsakkumulator 14 übertragen. Die Spuleneinheit 12 umfasst zumindest eine Kerneinheit 17 und zumindest eine Induktionsspule 18, die die zumindest eine Kerneinheit 17 zumindest teilweise umschließt (Figuren 4, 6). Die Kerneinheit 17 umfasst in dem gemäß Fig. 4 und 5 gezeigten Ausführungsbeispiel sechs im Wesentlichen formgleiche Kernelemente 16. Eine andere dem Fachmann als sinnvoll erscheinende Anzahl an Kernelementen 16 ist auch möglich. Es können mehr als sechs Kernelemente, z. B. acht Kernelemente, oder weniger als sechs Kernelemente, z. B. vier Kernelemente, zum Einsatz kommen. Die Kernelemente 16 bilden zusammen die Kerneinheit 17. Die Kerneinheit 17 weist einen im Wesentlichen kreisförmigen Querschnitt auf. Ein anderer als ein kreisförmiger Querschnitt ist ebenfalls möglich. Zum Beispiel kann die Kerneinheit einen im Wesentlichen rechteckigen Querschnitt aufweisen, wobei die Ecken insbesondere abgerundet ausgeführt sein können. Die Kernelemente 16 sind jeweils teilkreisförmig ausgebildet. In einem montierten Zustand sind die Kernelemente 16 so nebeneinander angeordnet, dass die sechs Kernelemente 16 zusammen eine im Wesentlichen kreisförmige Kontur bilden. Die Kernelemente 16 bilden im Wesentlichen formgleiche Kreissektoren der im Wesentlichen kreisförmigen Kerneinheit 17. Die Kernelemente 16 weisen jeweils einen Überstand 44 in einem in der Radialrichtung 48 nach außen weisenden Bereich der Kernelemente 16 auf. Der Überstand 44 ist auf einer der Induktionsspule 18 zugewandten Seite des Kernelements 16 vorgesehen. Im Bereich des Überstands 44 weist das jeweilige Kernelement 16 eine geringere Erstreckung in der Axialrichtung 46 auf als im Bereich eines Grundkörpers 43 (Figuren 4, 6). Im Bereich zwischen dem Grundkörper 43 und dem Überstand 44 ist ein Absatz 45 ausgebildet. Die äußere kreisförmige Kontur des Überstands 44 hat einen größeren Durchmesser als die im Bereich des Absatzes 45 radial nach außen weisende Kontur des Grundkörpers 43. Die der Induktionsspule 18 abgewandte Seite des Kernelements 16 wird von einer im Wesentlichen ebenen Fläche gebildet (Figur 5). Die Kerneinheit 17 ist zu einer Erhöhung einer Induktivität der zumindest einen Induktionsspule 18 vorgesehen. Die Kernelemente 16 sind aus einem Metall gebildet. Die Kernelemente 16 sind als Ferritkerne ausgebildet.

Die Induktionsspule 18 umgreift die Kernelemente 16 in einem montierten Zustand in Umfangsrichtung 42 in zumindest einer Ebene (Figur 6). Die Induktionsspule 18 weist in der dargestellten Ausführungsform gemäß Figur 6 mehrere übereinander angeordnete Wicklungen 19 auf. Die Induktionsspule 18 weist zwei Spulenanschlüsse 26 auf, die beabstandet zueinander ausgebildet sind. Die Induktionsspule 18 weist eine runde Kontur auf. Insbesondere Figur 4 ist zu entnehmen, dass die Induktionsspule 18 eine im Wesentlichen kreisförmige Grundform hat. Die Induktionsspule kann alternativ auch eine nicht kreisförmige, zum Beispiel ovale, rechteckige oder quadratische Grundform haben (nicht dargestellt).

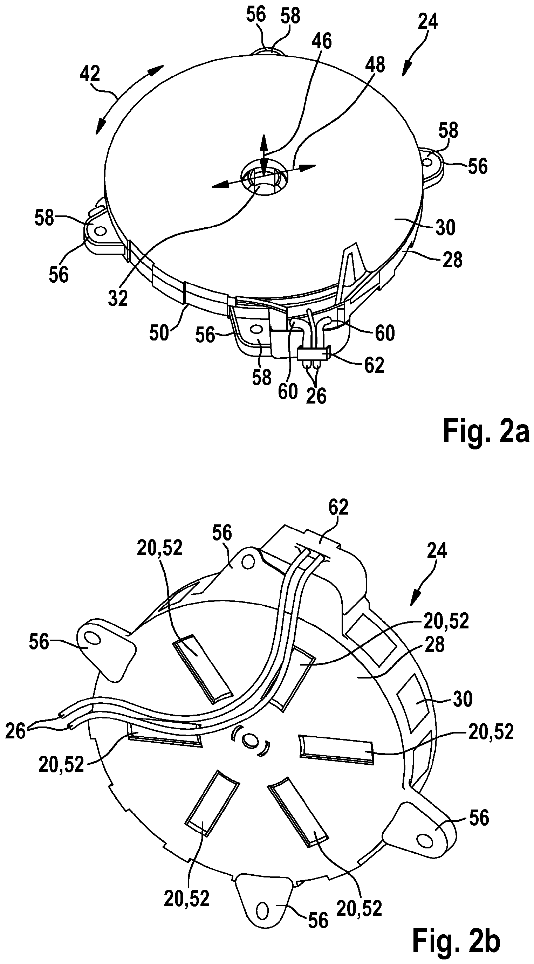

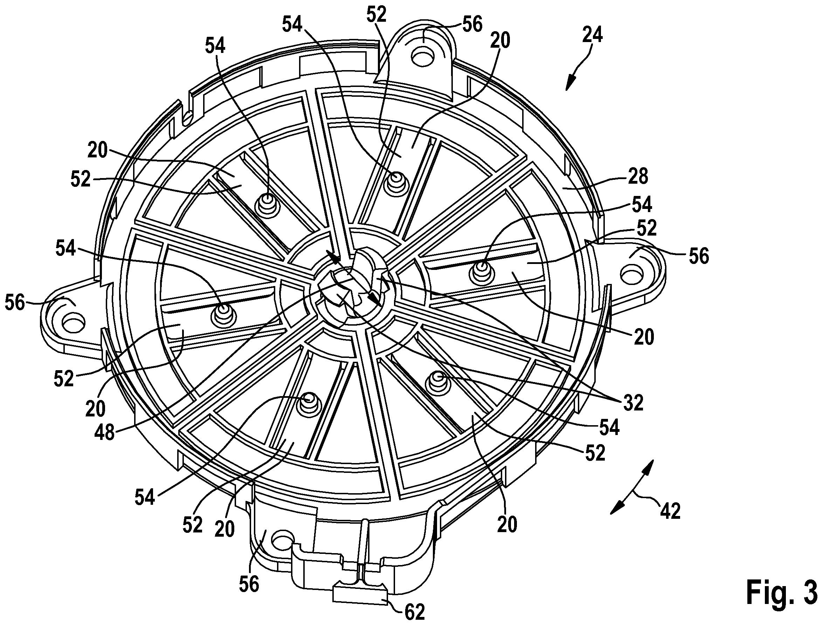

Die Induktionsladevorrichtung 10 weist ferner ein erstes Spulengehäuseelement 28 auf. Die Induktionsladevorrichtung 10 weist außerdem ein zweites Spulengehäuseelement 30 auf. Die Spulengehäuseelemente 28, 30 bilden zusammen die Spulengehäuseeinheit 24. Die Spulengehäuseeinheit 24 umschließt die Spuleneinheit 12. Die Spulengehäuseeinheit 24 und die Spuleneinheit 12 bilden die Induktionsladeeinheit 11. Die Spulengehäuseeinheit 24 weist eine größtenteils zylinderförmige Außenkontur auf (Figuren 2a, 2b). Die Spulengehäuseeinheit 24 weist zwei Spulengehäuseelemente 28, 30, die in einem montierten Zustand über zumindest ein Verbindungselement miteinander gekoppelt sind. Die Spulengehäuseelemente 28, 30 weisen jeweils zumindest ein Verbindungselement auf, das jeweils mit dem Verbindungselement des jeweils anderen Spulengehäuseelements 28, 30 korrespondierend ausgebildet ist. In der dargestellten Ausführungsform der Spulengehäuseeinheit 24 nach Fig. 3, 4 und 5 sind die korrespondierenden Verbindungselemente als Rastelemente ausgeführt. Die Spulengehäuseelemente 28, 30 sind über korrespondierende Rastelemente 32, 50 miteinander lösbar gekoppelt. Ein erstes der Spulengehäuseelemente 28 weist zwei Rastelemente 32 auf (Figur 3). Die Rastelemente 32 sind fest mit dem ersten Spulengehäuseelement 28 verbunden. Die Rastelemente 32 sind einstückig mit dem ersten Spulengehäuseelement 28 ausgebildet. Die Rastelemente 32 sind von Schnapphaken gebildet. Die Rastelemente 32 sind in einem Zentrum des ersten Spulengehäuseelements 28 angeordnet. Die Rastelemente 32 sind federelastisch in Radialrichtung 48 des ersten Spulengehäuseelements 28 auslenkbar ausgebildet. Das zweite Spulengehäuseelement 30 weist eine Rastausnehmung 50 auf, die mit den Rastelementen 32 des ersten Spulengehäuseelements 28 korrespondierend ausgebildet ist. Die Rastausnehmung 50 ist in einem Zentrum des weiteren Spulengehäuseelements 30 angeordnet. In einem montierten Zustand greifen die Rastelemente 32 des ersten Spulengehäuseelements 28 durch die Rastausnehmung 50 des weiteren Spulengehäuseelements 30 und sind mit dieser verrastet (Figuren 2a, 2b, 6). Alternative Ausführungsformen für die einander korrespondierenden Verbindungselemente 32, 50 zur lösbaren Kopplung der beiden Spulengehäuseelemente 28, 30 sind möglich.

Das Spulengehäuseelement 30 ist dazu vorgesehen, die Induktionsspule 18 aufzunehmen. Das Spulengehäuseelement 30 ist als Spulenträger ausgebildet. Hierfür weist das Spulengehäuseelement 30 eine nutförmige Ausnehmung 31 in Umfangsrichtung 42 auf. Die Wicklungen 19 der Induktionsspule 18 sind in der nutförmigen Ausnehmung 31 aufgenommen. Die Wicklungen 19 sind in die nutförmige Ausnehmung 31 eingebracht. Die Wicklungen 19 sind in die nutförmige Ausnehmung 31 aufgewickelt.

Zudem ist das Spulengehäuseelement 30 dazu vorgesehen, die Kerneinheit 17 aufzunehmen. Das Spulengehäuseelement 30 weist zumindest einen Aufnahmebereich für die Kerneinheit 17 auf. In der nach Fig. 5 dargestellten Ausführungsform weist das Spulengehäuseelement 30 eine der Anzahl der Kernelemente 16 entsprechende Anzahl an Aufnahmebereichen 33 auf. So ist für jedes Kernelement 16 ein Aufnahmebereich 33 zur Aufnahme eines Kernelements 16 vorgesehen. Der Aufnahmebereich 33 nimmt das Kernelement 16 im Wesentlichen vollständig auf. Der Aufnahmebereich 33 weist eine der Form des Kernelements 16 im Wesentlichen korrespondierende Form auf. Figur 5 ist zu entnehmen, dass der Aufnahmebereich 33 insbesondere die aus dem Grundkörper 43, dem Überstand 44 und dem Absatz 45 gebildete Kontur der der Induktionsspule 18 zugewandten Seite des Kernelements 16 nachbildet. Jeweils ein Aufnahmebereich 33 ist von zwei Seitenwänden 35 begrenzt. Zwei benachbarte Aufnahmebereiche 33 sind durch eine Seitenwand 35 voneinander getrennt. Mit Hilfe der Seitenwand 35 sind zwei benachbart zueinander angeordnete Kernelemente 16 beabstandet angeordnet.

Die Kernelemente 16 und die Induktionsspule 18 der Spuleneinheit 12 sind in einem montierten Zustand zumindest nahezu vollständig in dem Spulengehäuseelement 30 eingefasst.

Die Induktionsladevorrichtung 10 weist zudem zumindest ein Federelement 20 auf, das zumindest teilweise dazu vorgesehen ist, das zumindest eine Kernelement 16 zumindest teilweise zu der zumindest einen Induktionsspule 18 hin mit einer Kraft zu beaufschlagen. Die Induktionsladevorrichtung 10 umfasst sechs formgleiche Federelemente 20, die dazu vorgesehen sind, jeweils eines der Kernelemente 16 zu der Induktionsspule 18 hin mit einer Kraft zu beaufschlagen. Die Federelemente 20 drücken jeweils die Kernelemente 16 in Axialrichtung 46 zu der Induktionsspule 18 hin. Die Federelemente 20 bewirken jeweils eine Kraft auf die Kernelemente 16 in Axialrichtung 46 in Richtung des Aufnahmebereichs 22 der Induktionsladevorrichtung 10 zur Aufnahme des Induktionsakkumulators 14. Die Induktionsladeeinheit 11 der Induktionsladevorrichtung 10 weist das zumindest eine Federelement 20 auf. Dabei weist die Spulengehäuseeinheit 24 das zumindest eine Federelement 20 auf. Die Federelemente 20 sind fest mit der Spulengehäuseeinheit 24 verbunden. Das erste Spulengehäuseelement 28 weist das zumindest eine Federelement 20 auf. Die Federelemente 20 sind fest mit dem ersten Spulengehäuseelement 28 der Spulengehäuseeinheit 24 verbunden. Die Federelemente 20 sind einstückig mit der Spulengehäuseeinheit 24 ausgebildet. Die Federelemente 20 sind einstückig mit dem ersten Spulengehäuseelement 28 der Spulengehäuseeinheit 24 ausgebildet. Die Federelemente 20 drücken die Kernelemente 16 in Axialrichtung 46 zu dem zweiten Spulengehäuseelement 30 hin, welches die nutförmige Ausnehmung 31 zur Aufnahme der Induktionsspule 18 aufweist. Damit drücken die Federelemente 20 des ersten Spulengehäuseelements 28 die Kernelemente 16 in Axialrichtung zu der Induktionsspule 18 in dem zweiten Spulengehäuseelement 30.

In einer alternativen, nicht dargestellten Ausführungsform kann das zweite Spulengehäuseelement 30 das zumindest eine Federelement aufweisen. Das alternative Federelement kann ebenfalls dazu vorgesehen sein, das zumindest eine Kernelement 16 zumindest teilweise zu der zumindest einen Induktionsspule 18 hin mit einer Kraft zu beaufschlagen. Das alternative Federelement kann fest mit dem zweiten Spulengehäuseelement 30 verbunden sein. Das alternative Federelement kann insbesondere einstückig mit dem zweiten Spulengehäuseelement 30 ausgebildet sein.

Die Federelemente 20 weisen jeweils einen Federkörper 52 und einen Fortsatz 54 auf. Der Federkörper 52 des Federelements 20 ist plattenförmig ausgebildet und weist eine im Vergleich zu einer Länge in Haupterstreckungsrichtung geringe Materialstärke auf. Der Federkörper 52 des Federelements 20 weist eine rechteckige Kontur entlang einer Haupterstreckungsebene auf. Der Federkörper 52 des Federelements 20 ist an Kopfseiten mit dem ersten Spulengehäuseelement 28 direkt verbunden. Der Federkörper 52 des Federelements 20 ist an den Kopfseiten mit dem ersten Spulengehäuseelement 28 einstückig ausgebildet. Längsseiten des Federkörpers 52 des Federelements 20 sind jeweils durch einen Schlitz beabstandet zu dem ersten Spulengehäuseelement 28 angeordnet. Über die Längsseiten des Federkörpers 52 des Federelements 20 ist das Federelement 20 nicht direkt mit dem ersten Spulengehäuseelement 28 verbunden. Dadurch ist der Federkörper 52 des Federelements 20 federelastisch ausgebildet. Der Fortsatz 54 des Federelements 20 ist mittig auf dem Federkörper 52 in der Haupterstreckungsebene des Federkörpers 52 angeordnet. Der Fortsatz 54 ist einstückig mit dem Federkörper 52 des Federelements 20 ausgebildet. Der Fortsatz 54 ist zylinderförmig ausgebildet, wobei eine Rotationsachse des zylinderförmig ausgebildeten Fortsatzes 54 parallel zur Haupterstreckungsebene des Federkörpers 52 verläuft. In einem montierten Zustand kontaktiert der Fortsatz 54 jeweils eines der Federelemente 20 jeweils eines der Kernelemente 16. Der Fortsatz 54 des Federelements 20 überträgt die Federkraft des Federkörpers 52 des Federelements 20 direkt auf das jeweilige Kernelement 16 und drückt das Kernelement 16 dadurch zu dem Aufnahmebereich 22 und zu dem weiteren Spulengehäuseelement 30 hin. Die Federelemente 20, die einstückig mit dem ersten Spulengehäuseelement 28 ausgebildet sind, und das weitere Spulengehäuseelement 30 sind dazu vorgesehen, die Kernelemente 16 in einem montierten Zustand einzuspannen. Alternativ oder zusätzlich ist es auch denkbar, dass das zumindest eine Federelement 20 zumindest teilweise aus einem Elastomer gebildet ist oder auf eine andere, einem Fachmann als sinnvoll erscheinende Weise ausgebildet ist.

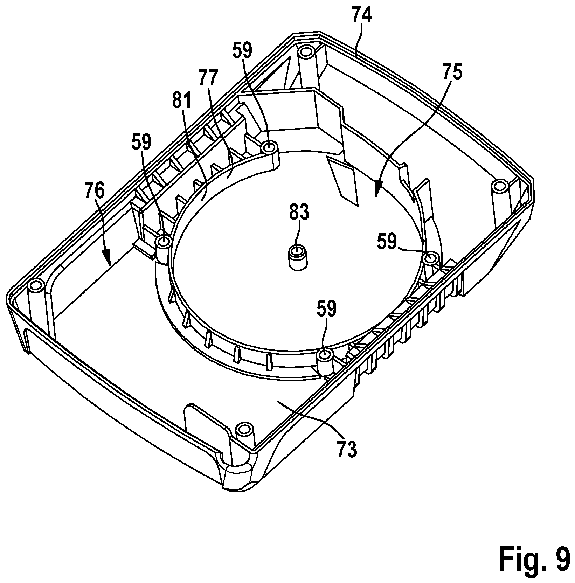

Bei einer Montage werden in einem ersten Schritt die Induktionsspule 18 und die Kernelemente 16 der Spuleneinheit 24 in das Spulengehäuseelement 30 der Spulengehäuseeinheit 24 eingebracht. Anschließend wird das erste Spulengehäuseelement 28 der Spulengehäuseeinheit 24, das die Federelemente 20 aufweist, über das weitere Spulengehäuseelement 30 geschoben und in Axialrichtung 46 soweit zusammengedrückt, dass das erste Spulengehäuseelement 28 und das weitere Spulengehäuseelement 30 der Spulengehäuseeinheit 24 vollständig übereinanderliegen. Dabei umgreift das erste Spulengehäuseelement 28 das weitere Spulengehäuseelement 30 in Umfangsrichtung 42 vollständig. In der dargestellten Ausführungsform weisen die Spulengehäuseelemente 28, 30 der Spulengehäuseeinheit 24 jeweils zumindest eine Haltelasche 56, 58 auf. Die Spulengehäuseelemente 28, 30 der Spulengehäuseeinheit 24 weisen jeweils insgesamt vier Haltelaschen 56, 58 auf. Die Haltelaschen 56, 58 sind gleichmäßig über einen Umfang der Spulengehäuseelemente 28, 30 der Spulengehäuseeinheit 24 verteilt angeordnet. Die Haltelaschen 58 des weiteren Spulengehäuseelements 30 greifen in einem gekoppelten Zustand der Spulengehäuseeinheit 24 jeweils in eine Haltelasche 56 des ersten Spulengehäuseelements 28. Die Haltelaschen 56, 58 weisen jeweils eine Befestigungsausnehmung auf, durch die in einem montierten Zustand eine Schraube greift, mittels der die Spulengehäuseeinheit 24 mit dem Gehäuse 34 der Induktionsladevorrichtung 10 verschraubt ist. Die Spulengehäuseeinheit 24 ist in einem montierten Zustand somit mit dem Gehäuse 34 der Induktionsladevorrichtung 10 verschraubt. Durch die Verschraubung der Spulengehäuseeinheit 24 mit dem Gehäuse 34 der Induktionsladevorrichtung 10 werden zudem das erste Spulengehäuseelement 28 und das weitere Spulengehäuseelement 30 miteinander verspannt und relativ zueinander gesichert sowie die Induktionsladeeinheit 11 relativ zu dem Aufnahmebereich 22 der Induktionsladevorrichtung lagegesichert. Wie weiter unten in Zusammenhang mit Figur 9 erläutert, sind für die Verschraubung der Spulengehäuseeinheit 24 mit dem Gehäuse 34 Halteelemente 59 in Form von Schraubdomen vorgesehen.

Die Haltelaschen 56, 58 und Schraubdome 59 stellen eine Ausführungsform von Halteelementen dar, welche dazu ausgebildet sind, zumindest eines der Spulengehäuseelemente 28, 30 mit dem Gehäuse 34 lösbar zu befestigen und relativ zu dem Aufnahmebereich 22 anzuordnen. Alternative Ausführungsformen für Halteelemente zur lösbaren Befestigung der Induktionsladeeinheit 11 mit dem Gehäuse 34 und zur Anordnung der Induktionsladeeinheit 11 relativ zu dem Aufnahmebereich 22 sind möglich. Beispielsweise können die Halteelemente in Form von Rastelementen oder anderen Verbindungselementen zur formschlüssigen und/oder kraftschlüssigen Verbindung ausgeführt sein.

Das Spulengehäuseelement 30 der Spulengehäuseeinheit 24 weist zudem zwei Spulenanschlussdurchführungen 60 auf, die dazu vorgesehen sind, die Spulenanschlüsse 26 der Induktionsspule 18 aus einem Inneren der Spulengehäuseeinheit 24 in einem montierten Zustand nach außen zu führen (Figur 2a). Die Spulenanschlussdurchführungen 60 sind von Ausnehmungen in dem weiteren Spulengehäuseelement 30 gebildet. Die Spulenanschlussdurchführungen 60 sind beabstandet zueinander angeordnet. Das erste Spulengehäuseelement 28 weist ein Spulenanschlusshalteelement 62 auf, das dazu vorgesehen sind, die Spulenanschlüsse 26 der Induktionsspule 18 aus einem Inneren der Spulengehäuseeinheit 24 in einem montierten Zustand zu befestigen und zu halten (Figur 2b). Das Spulenanschlusshalteelement 62 befestigt die Spulenanschlüsse 26 der Induktionsspule 18 außen an der Spulengehäuseeinheit 24. Das Spulenanschlusshalteelement 62 befestigt die Spulenanschlüsse 26 der Induktionsspule 18 beabstandet zueinander. Dadurch kann eine hohe elektrische Isolation, insbesondere von bis zu 1500 Volt, erreicht werden.

Figur 7 zeigt die Induktionsladevorrichtung 10 vor einem Zusammenbau in einer perspektivischen Darstellung der einzelnen Bauteile. Das Gehäuse 34 bildet das Außengehäuse der Induktionsladevorrichtung 10. Das Gehäuse 34 ist in der Ausführung nach Figur 7 aus zwei Gehäuseelementen 72, 74 gebildet. Das Gehäuseelement 74 bildet ein oberes Gehäuseelement. Das obere Gehäuseelement 74 der Induktionsladevorrichtung 10 weist einen Aufnahmebereich 22 auf, der zur Aufnahme des Induktionsackumulators 14 in einem gekoppelten Zustand vorgesehen ist (Figur 1). Der Aufnahmebereich 22 des oberen Gehäuseelements 74 der Induktionsladevorrichtung 10 weist zumindest eine Vertiefung auf. Die Vertiefung bildet ein Positionierelement 40 zur Positionierung des Induktionsakkumulators 14. Das Gehäuseelement 72 bildet ein unteres Gehäuseelement. Das untere Gehäuseelement 72 und das obere Gehäuseelement 74 umschließen einen Innenbereich 76 der Induktionsladevorrichtung 10 zur Aufnahme der Induktionsladeeinheit 11 und der Elektronikeinheit 78. Die Elektronikeinheit 78 ist dazu vorgesehen, einen Ladevorgang zu steuern oder zu regeln. Die Elektronikeinheit 78 umfasst zumindest eine mit elektronischen Komponenten bestückte Leiterplatte 79.

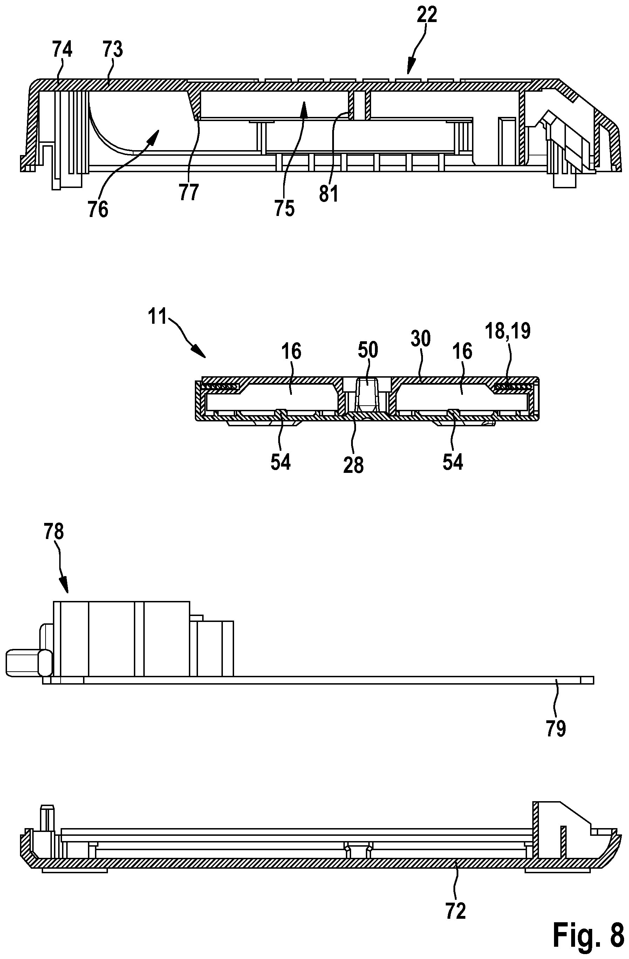

Figur 8 zeigt die Induktionsladevorrichtung 10 vor einem Zusammenbau in einem Längsschnitt durch die einzelnen Bauteile. Das obere Gehäuseelement 74 weist einen Aufnahmebereich 75 zur Aufnahme der Induktionsladeeinheit 11 auf. Der Aufnahmebereich 75 bildet einen Teilbereich des Innenbereichs 76 der Induktionsladevorrichtung 10. Der Aufnahmebereich 75 ist an einer nach innen zu dem Innenbereich 76 hin weisenden Innenseite einer oberen Gehäusewand 73 des Gehäuseelements 74 vorgesehen. Der Aufnahmebereich 75 befindet sich in einem dem Aufnahmebereich 22 gegenüberliegenden Bereich auf der Innenseite der Gehäusewand 73. Der Aufnahmebereich 22 ist an der Außenseite der Gehäusewand 73 und der Aufnahmebereich 75 an der Innenseite der Gehäusewand 73 vorgesehen, wobei der Aufnahmebereich 22 und der Aufnahmebereich 75 bezüglich der Gehäusewand 73 einander gegenüberliegend angeordnet sind. Der Aufnahmebereich 75 ist dazu ausgebildet, die Induktionsladeeinheit 11 relativ zu dem Aufnahmebereich 22 zu positionieren. Hierfür sind an der Innenseite der Gehäusewand 73 von der Gehäusewand 73 abstehende, in den Innenbereich 76 hineinragende Wandelemente 77 vorgesehen. Die Wandelemente 77 sind an der Innenseite der Gehäusewand 73 angeformt. Die Wandelemente 77 begrenzen den Aufnahmebereich 75 in seiner Umfangsrichtung. Die Wandelemente 77 begrenzen den Aufnahmebereich 75 in seiner Umfangsrichtung, wie in Fig. 9 dargestellt, im Wesentlichen vollständig. Dabei bilden die Wandelemente 77 die äußere Gestalt der Induktionsladeeinheit 11 in Umfangsrichtung im Wesentlichen komplementär ab. In der dargestellten Ausführungsform nach Fig. 9 bilden die Wandelemente 77 eine im Wesentlichen geschlossene Umfangswand 81, welche die Spulengehäuseeinheit 24 im Wesentlichen komplementär abbildet. Im montierten Zustand der Induktionsladeeinheit 11 an dem Gehäuseelement 74 umschließen die Wandelemente 77 die Spulengehäuseeinheit 24 in Umfangsrichtung 42 im Wesentlichen vollständig. In einer alternativen, nicht dargestellten Ausführung wäre es möglich, Wandelemente vorzusehen, welche den Aufnahmebereich 75 in Umfangsrichtung unvollständig begrenzen. Dies kann beispielsweise derart realisiert sein, dass die Wandelemente unterbrochen sind. Zusätzlich ist in der Ausführungsform nach Fig. 9 ein Positionierelement 83 vorgesehen, welches im montierten Zustand der Induktionsladeeinheit 11 an dem Gehäuseelement 74 in die Rastausnehmung 50 der Spulengehäuseeinheit 24 eingreift. Das Positionierelement 83 ist an die Innenseite der Gehäusewand 73 derart angeformt, dass es an der Innenseite der Gehäusewand 73 von der Gehäusewand 73 absteht und in den Innenbereich 76 hineinragt. Das Positionierelement 83 ist dazu ausgebildet, die Induktionsladeeinheit 11 relativ zu dem Gehäuseelement 74 zu positionieren.

Zur lösbaren Befestigung der Induktionsladeeinheit 11 mit dem Gehäuse 34 der Induktionsladevorrichtung 10 und damit zur lagesicheren Positionierung der Induktionsladeeinheit 11 relativ zu dem Aufnahmebereich 22 sind an dem Gehäuseelement 74 Halteelemente 59 vorgesehen. Die Halteelemente 59 wirken mit den an den Spulengehäuseelementen 28, 30 vorgesehenen Halteelementen 56, 58 zusammen. In der in Figur 9 dargestellten Ausführungsform sind die Halteelemente 59 als Schraubdome ausgebildet.

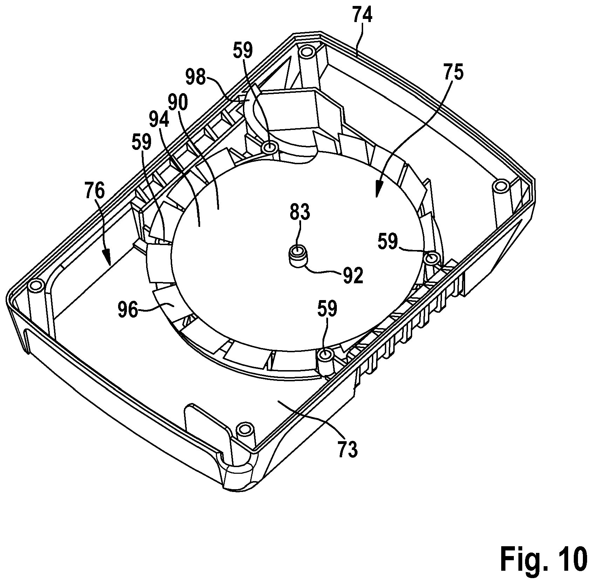

Figur 10 zeigt das Gehäuseelement 74 nach Figur 9, in dem ein Abschirmelement 90 angeordnet ist. Für die Funktion des Abschirmelements 90 ist wichtig, dass das Abschirmelement 90 in der Induktionsladevorrichtung 10 zwischen der Spuleneinheit 12 und dem Aufnahmebereich 22, insbesondere zwischen der Induktionsspule 18 und dem Aufnahmebereich 22, angeordnet ist. Dabei ist eine Seite des Abschirmelements 90 dem Aufnahmebereich 22 zugewandt, während die andere, gegenüberliegende Seite des Abschirmelements 90 der Induktionsspule 18 zugewandt ist. Somit ist während eines Ladevorgangs eines Induktionsakkumulators 14 mit der Induktionsladevorrichtung 10 das Abschirmelement 90 zwischen der Induktionsspule 18 und dem Induktionsakkumulator 14 bzw. zwischen der Induktionsspule 18 und einer Induktionsspule des Induktionsakkumulators 14 angeordnet. Für die Funktion des Abschirmelements 90 ist von Vorteil, wenn der Abstand zwischen der Induktionsspule 18 und dem Abschirmelement 90 möglichst gering ist.

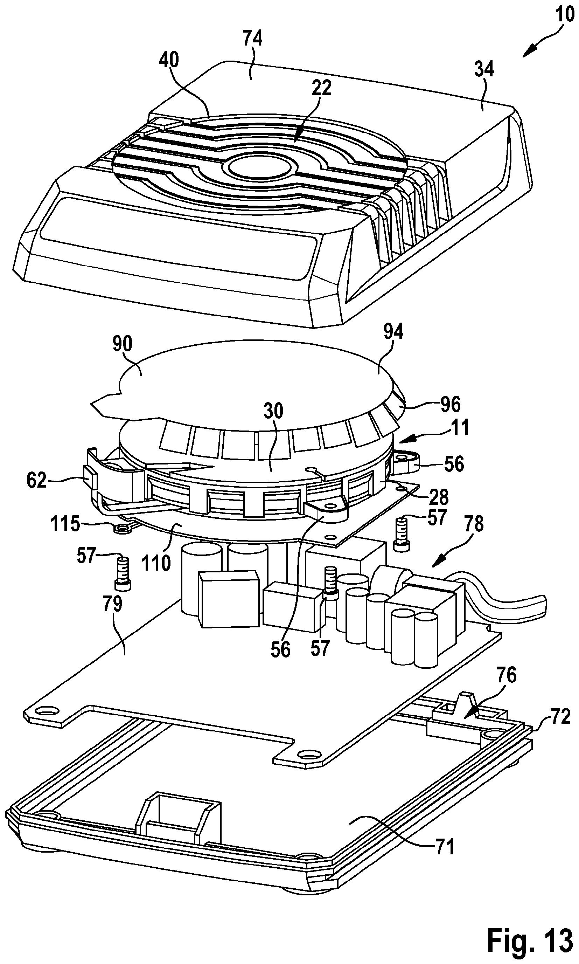

Die Anordnung des Abschirmelements 90 zwischen Aufnahmebereich 22 und Induktionsspule 18 erfolgt in der dargestellten Ausführungsform nach Figur 10 in Zusammenschau mit Figur 13 derart, dass das Abschirmelement 90 zwischen dem Gehäuseelement 74 und der Induktionsladeeinheit 11 angeordnet ist. Dabei ist das Abschirmelement 90 außerhalb der Induktionsladeeinheit 11 angeordnet. Das Abschirmelement 90 ist zwischen der Spulengehäuseeinheit 24 und dem Gehäuseelement 74 angeordnet. Das Abschirmelement 90 ist zwischen dem Spulengehäuseelement 30 der Spulengehäuseeinheit 24 und dem Gehäuseelement 74 angeordnet. Das Abschirmelement 90 ist zwischen einer Innenseite der Gehäusewand 73 und der der Gehäusewand 73 zugewandten Außenseite des Spulengehäuseelements 30 angeordnet. Somit entspricht der Abstand zwischen dem Abschirmelement 90 und der Induktionsspule 18 im Wesentlichen der Dicke der Gehäusewand des Spulengehäuseelements 30, die sich zwischen der Induktionsspule 18 und dem Abschirmelement 90 befindet. In einer alternativen nicht dargestellten Ausführungsform kann das Abschirmelement 90 auch ein Element der Induktionsladeeinheit 11 bilden, indem das Abschirmelement 90 innerhalb der Induktionsladeeinheit 11 angeordnet ist. Dabei kann das Abschirmelement 90 in der Spulengehäuseeinheit 24 angeordnet sein. Es kann dabei insbesondere in dem Spulengehäuseelement 30 angeordnet sein, welches die Induktionsspule 18 aufnimmt.

Das Abschirmelement 90 ist in dem Aufnahmebereich 75 des Gehäuseelements 74 angeordnet. Dabei ist das Abschirmelement 90 mit Hilfe des Positionierelements 83 relativ zu dem Aufnahmebereich 75 positioniert. Hierfür weist das Abschirmelement 90 eine Öffnung 92 auf, welche das Positionierelement 83 des Gehäuseelements 74 aufnimmt. Mit Hilfe der Öffnung 92 und dem Positionierelement 83 wird das Abschirmelement 90 relativ zu dem Gehäuseelement 74 bzw. relativ zu dem Aufnahmebereich 75 positioniert. Im Einbauzustand der Induktionsladeeinheit 11 in dem Gehäuseelement 74 ist das Abschirmelement 90 zwischen das Gehäuseelement 74 und die Spulengehäuseeinheit 24 der Induktionsladeeinheit 11 geklemmt.

Für die Funktion des Abschirmelements 90 ist von Vorteil, wenn das Abschirmelement 90 eine möglichst große Ausdehnung in der Fläche, bezogen auf die von der Induktionsspule 18 umfasste Fläche, aufweist. Das Abschirmelement 90 weist eine Ausdehnung in der Fläche auf, welche mindestens im Wesentlichen der Fläche entspricht, die von der Induktionsspule 18 gebildet wird. Hierfür weist das Abschirmelement 90 ein Bodenelement 94 auf, dessen Fläche im Wesentlichen der von der Induktionsspule 18 gebildeten Fläche entspricht. Das Bodenelement 94 ist insbesondere vollflächig ausgebildet. Bei einer Anordnung des Abschirmelements 90 zwischen Aufnahmebereich 22 und Induktionsspule 18 bzw. zwischen Aufnahmebereich 22 und Spuleneinheit 12 in der Induktionsladevorrichtung 10 bedeckt das Abschirmelement 90 die Induktionsspule 18 im Wesentlichen vollständig. Die Fläche des Abschirmelements 90 kann alternativ auch größer als die von der Induktionsspule 18 umfasste Fläche sein. Dabei kann die Fläche des Bodenelements 94 größer als die von der Induktionsspule 18 gebildete Fläche sein.

Für die Funktion des Abschirmelements 90 ist ferner von Vorteil, wenn das Abschirmelement 90 nicht nur die dem Aufnahmebereich 22 zugewandte Fläche der Induktionsspule 18 bedeckt, sondern auch die äußere Umfangsfläche der Induktionsspule 18 umschließt. Hierfür weist das Abschirmelement 90 eine Mehrzahl von Wandelementen 96 auf, welche an dem Bodenelement 94 angeordnet sind. Wie in den Figuren 10 und 13 erkennbar, sind in der Einbaulage des Abschirmelements 90 in dem Gehäuseelement 74 die Wandelemente 96 seitlich an der Induktionsladeeinheit 11 angeordnet, so dass das Abschirmelement 90 die Induktionsspule 18 bzw. die Spuleneinheit 12 seitlich im Wesentlichen vollständig umschließt. Die Wandelemente 96 bilden in der Einbaulage eine im Wesentlichen geschlossene Umfangswand, welche die Induktionsspule 18 bzw. die Spuleneinheit 20 an ihrem seitlichen Außenumfang im Wesentlichen vollständig umschließt. Wie oben beschrieben, ist in der dargestellten Ausführungsform das Abschirmelement 90 außerhalb der Spulengehäuseeinheit 24 angeordnet, so dass in der Einbaulage das Abschirmelement 90 auch eine seitliche Umfangswand zumindest des Spulengehäuseelements 30 zumindest teilweise umschließt.

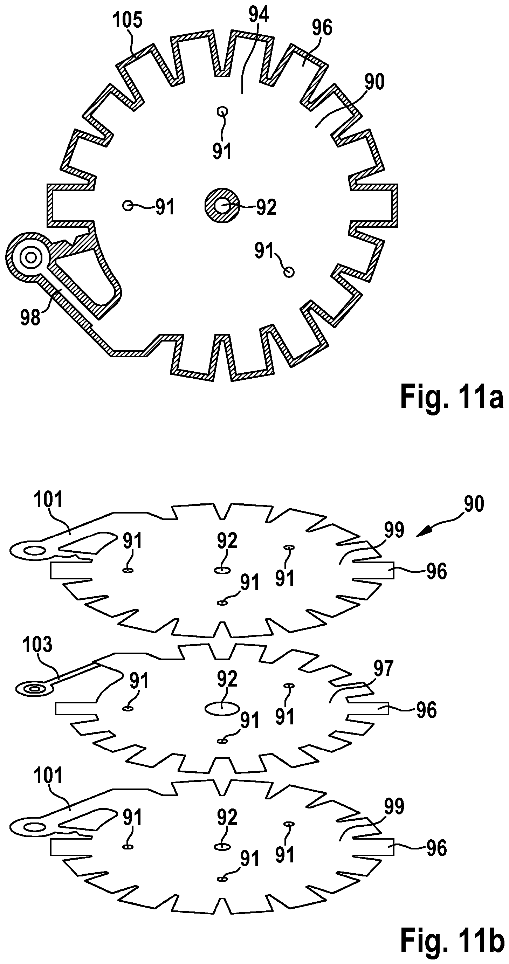

In den Figuren 11a und 11b ist das Abschirmelement 90 näher dargestellt. In der Draufsicht nach Figur 11a ist das im Wesentlichen scheibenförmige Bodenelement 94 erkennbar, welches in etwa mittig die Öffnung 92 zur Aufnahme des Positionierelements 83 des Gehäuseelements 74 aufweist. Ferner sind die von dem Bodenelement 94 radial nach außen abstehenden Wandelemente 96 erkennbar. Die Wandelemente 96 sind einteilig mit dem Bodenelement 94 ausgebildet. Die Wandelemente 96 stehen fahnenartig von dem Bodenelement 94 radial nach außen ab. Wie bereits oben beschrieben, bilden die Wandelemente 96 in der Einbaulage in der Induktionsladevorrichtung 10 eine seitlich von dem Bodenelement 94 abstehende Umfangswand. Die Wandelemente 96 sind dabei zu dem Bodenelement 94 geneigt angeordnet. Sie können in der Einbaulage zum Beispiel im Wesentlichen senkrecht zu dem Bodenelement 94 ausgerichtet sein. Anstelle einer Mehrzahl von Wandelementen 96 kann auch ein einzelnes Wandelement vorgesehen sein, welches eine im Wesentlichen geschlossene seitliche Umfangswand des Abschirmelements 90 bildet (nicht dargestellt). Das Abschirmelement 90 hat eine im Wesentlichen runde Grundform. Dabei ist die Grundform des Abschirmelements 90 an die Grundform der Induktionsspule 18 angepasst. In einer (nicht dargestellten) Ausführungsform, in der die Induktionsspule eine nicht runde Grundform hat, zum Beispiel eine ovale, rechteckige oder quadratische Grundform, hat das Abschirmelement vorteilhafterweise eine entsprechenden nicht runde, zum Beispiel ovale, rechteckige oder quadratische Grundform.

Des Weiteren umfasst das Abschirmelement 90 ein elektrisches Kontaktelement 98, welches dazu ausgebildet ist, eine elektrische Verbindung zu dem Abschirmelement 90 herzustellen. Das Kontaktelement 98 ist an dem Bodenelement 94 angeordnet. Es steht von dem Bodenelement 94 fahnenartig nach außen ab.

Figur 11b ist zu entnehmen, dass das Abschirmelement 90 als dünne Abschirmfolie ausgebildet ist. Es ist insbesondere mehrlagig aufgebaut. In der dargestellten Ausführungsform umfasst das Abschirmelement 90 drei Lagen. Die erste Lage und die dritte Lage werden von jeweils einem Isolierelement 99 in Form einer Isolierfolie gebildet. Die zwischen der ersten und der dritten Lage angeordnete zweite Lage wird von einem elektrisch leitfähigen Element 97 gebildet. Die Isolierelemente 99 sind aus einem elektrisch nicht leitenden Material gebildet. Sie sind zum Beispiel als Kunststofffolien ausgeführt. Der Kunststoff kann zum Beispiel Polyester sein. Die Dicke der Isolierfolien 99 beträgt zum Beispiel weniger als 0,1 mm. Die Isolierfolien 99 sind dazu ausgebildet, elektrische Durchschläge zwischen der Induktionsspule 18 und dem elektrisch leitfähigen Element 97 zu verhindern. Die Durchschlagsfestigkeit der Isolierelemente 99 beträgt zum Beispiel mehr als 2 kV. Das elektrisch leitfähige Element 97 ist aus einem elektrisch leitfähigen Material gebildet. Es hat sich erwiesen, dass metallische, insbesondere ferromagnetische, Werkstoffe als leitfähiges Material für das leitfähige Element 97 eher ungeeignet sind. Ein nicht metallischer Werkstoff, wie zum Beispiel Kohlenstoff, ist für das elektrisch leitfähige Element 97 von Vorteil. Das elektrisch leitfähige Element 97 kann zum Beispiel als ein Flächengebilde von Kohlenstofffasern ausgeführt sein, wobei das Flächengebilde von einem Gelege, Gewirke, Gewebe, Gestricke, Geflecht, Netz, Filz, Vlies oder dergleichen gebildet ist.

Zum Zwecke der Positionierung der beiden Isolierelemente 99 und des elektrisch leitfähigen Elements 97 relativ zueinander ist jedes der Elemente 97, 99 mit zumindest drei Positionierelementen 91 in Form von Positionierlöchern versehen. Beim Zusammenbau des Abschirmelements 90 dienen die Positionierelemente 91 als Montagehilfe für die genaue Ausrichtung der einzelnen Lagen zueinander. Bei einer Anordnung der Isolierelemente 99 und des elektrisch leitfähigen Elements 97 übereinander ist jedes Positionierelement 91 eines der Elemente 97, 99 jeweils mit zumindest einem Positionierelement 91 eines benachbarten Elements 97, 99 fluchtend angeordnet.

In einem umlaufenden Randbereich 105 des Abschirmelements 90 sind die Isolierelemente 99 gegenüber dem elektrisch leitfähigen Element 97 mit einem Überstand versehen. In diesem Randbereich 105 liegen die beiden Isolierelemente 99 direkt aneinander an, ohne dass das elektrisch leitfähige Element 97 dazwischen liegt. In dem Randbereich 105 sind die Isolierelemente 99, insbesondere stoffschlüssig, zum Beispiel durch Kleben oder Schweißen, insbesondere unmittelbar miteinander verbunden. Demnach ist der Randbereich 105 frei von dem elektrisch leitfähigen Element 97. Der Randbereich 105 ist insbesondere gänzlich frei von elektrisch leitfähigem Material. Der Randbereich 105 ist dazu ausgebildet, die elektrische Durchschlagsfestigkeit zu gewährleisten. Der Randbereich erstreckt sich zum Beispiel über zumindest 0,5 mm ausgehend von der äußeren Kante des Abschirmelements 90.

Das fahnenartig von dem Bodenelement 94 abstehende elektrische Kontaktelement 98, welches zur elektrischen Anbindung des Abschirmelements 90 ausgebildet ist, ist ebenfalls aus drei Lagen aufgebaut. Von den Bodenelementen der beiden Isolierelemente 99 steht jeweils eine Isolierfahne 101 ab. Von dem Bodenelement des elektrisch leitfähigen Elements 97 steht eine Kontaktfahne 103 ab. Dabei liegt die Kontaktfahne 103 zwischen den beiden Isolierfahnen 101. Die Isolierfahnen 101 sind einteilig mit den Bodenelementen der Isolierelemente 99 ausgebildet. Für die Kontaktfahne 103 wird bevorzugt ein metallischer Werkstoff, zum Beispiel eine Kupferfolie, verwendet. Dabei ist die Kontaktfahne 103 aus Kupferfolie elektrisch leitend mit dem Flächengebilde aus elektrisch leitfähigem Material des elektrisch leitfähigen Elements 97 verbunden.

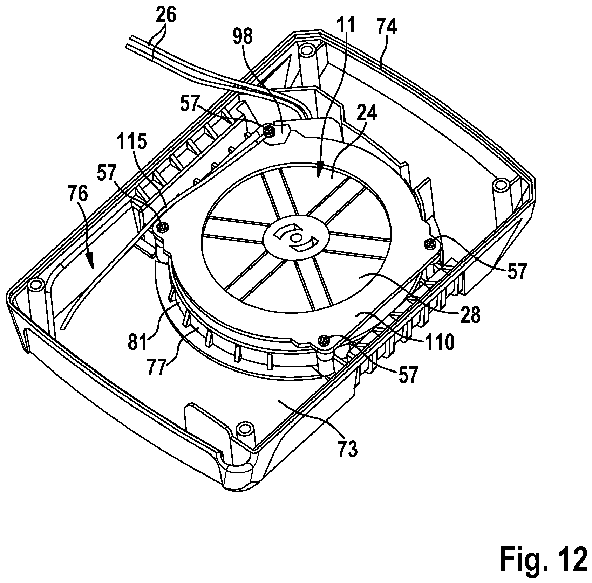

Figur 12 zeigt das Gehäuseelement 74 nach Figur 9, in dem die Induktionsladeeinheit 11 und ein Abschirmelement 110 angeordnet ist. Für die Funktion des Abschirmelements 110 ist wichtig, dass das Abschirmelement 110 in der Induktionsladevorrichtung 10 zwischen der Spuleneinheit 12 und dem Gehäuseelement 72, insbesondere zwischen der Induktionsspule 18 und dem Gehäuseelement 72, angeordnet ist. Dabei ist eine Seite des Abschirmelements 110 dem Gehäuseelement 72 zugewandt, während die andere, gegenüberliegende Seite des Abschirmelements 110 der Induktionsspule 18 zugewandt ist. Somit ist während eines Ladevorgangs eines Induktionsakkumulators 14 mit der Induktionsladevorrichtung 10 das Abschirmelement 110 zwischen der Induktionsspule 18 und dem Gehäuseelement 72 angeordnet. Während des Ladevorgangs bildet das Gehäuseelement 72 das untere Gehäuseelement der Induktionsladevorrichtung 10, welches eine Standfläche für die Induktionsladevorrichtung 10, zum Beispiel auf einer Tischfläche, bildet.

Die Anordnung des Abschirmelements 110 zwischen Gehäuseelement 72 und Induktionsspule 18 erfolgt in der dargestellten Ausführungsform nach Figur 12 in Zusammenschau mit Figur 13 derart, dass das Abschirmelement 110 zwischen dem GehäuseeIement 72 und der Induktionsladeeinheit 11 angeordnet ist. Dabei ist das Abschirmelement 110 außerhalb der Induktionsladeeinheit 11 angeordnet. Das Abschirmelement 110 ist zwischen der Spulengehäuseeinheit 24 und dem Gehäuseelement 72 angeordnet. Das Abschirmelement 110 ist zwischen dem Spulengehäuseelement 28 und dem Gehäuseelement 74 angeordnet. Das Abschirmelement 110 ist zwischen einer Innenseite der Gehäusewand 71 und der der Gehäusewand 71 zugewandten Außenseite des Spulengehäuseelements 28 angeordnet. In einer alternativen nicht dargestellten Ausführungsform kann das Abschirmelement 110 auch ein Element der Induktionsladeeinheit 11 bilden, indem das Abschirmelement 110 innerhalb der Induktionsladeeinheit 11 angeordnet ist. Dabei kann das Abschirmelement 110 in der Spulengehäuseeinheit 24 angeordnet sein. Es kann dabei insbesondere in dem Spulengehäuseelement 28 angeordnet sein, welches dem Gehäuseelement 72 zugewandt ist. Dabei kann das Abschirmelement 110 insbesondere zwischen dem Spulengehäuseelement 28 und der Kerneinheit 17 bzw. den Kernelementen 16 angeordnet sein.

In der dargestellten Ausführungsform ist das Abschirmelement 110 in der Induktionsladevorrichtung 10 mittels Befestigungselementen 57 in Form von Schrauben lösbar befestigt. Die Befestigungselemente 57 wirken mit den Halteelementen 59 des Gehäuseelements 74 zusammen. Damit ist das Abschirmelement 110 lösbar an dem Gehäuseelement 74 befestigt. Wie Figur 12 zu entnehmen ist, übernimmt eines der Befestigungselemente 57 zusätzlich die Funktion, eine elektrisch leitfähige Verbindung zwischen dem Abschirmelement 110 und einer elektrischen Leitung 115 in Form eines elektrischen Kabels herzustellen. Über die elektrische Leitung 115 ist das Abschirmelement 110 mit einer Masse verbunden. Wie ferner Figur 12 zu entnehmen ist, übernimmt dieses Befestigungselement 57 zusätzlich die Funktion, eine elektrisch leitfähige Verbindung zwischen dem Kontaktelement 98 des Abschirmelements 90 und der elektrischen Leitung 115 herzustellen. Über die elektrische Leitung 115 ist somit auch das Abschirmelement 90 mit einer Masse verbunden.

Das Abschirmelement 110 ist aus einem elektrisch leitfähigen Material gebildet. Es ist vorteilhaft aus einem metallischen Material, zum Beispiel Aluminium, gebildet. Das Abschirmelement 110 ist dazu ausgebildet, die Induktionsspule 18 gegenüber metallischen Objekten abzuschirmen, die sich auf einer Standfläche für die Induktionsladevorrichtung 10, zum Beispiel einer Tischfläche, befinden. Eine Standfläche aus einem metallischen Werkstoff oder metallische Partikel auf der Standfläche beeinflussen die Funktion der Induktionsspule 18 in unvorteilhafter Weise.

In der in Fig. 12 gezeigten Ausführungsform ist das Abschirmelement 110 im Wesentlichen ringförmig ausgebildet. In einer alternativen nicht dargestellten Ausführungsform kann das Abschirmelement auch scheibenförmig ausgebildet sein. Das Abschirmelement kann dabei insbesondere im Wesentlichen vollflächig ausgebildet sein. Zur Erreichung einer ausreichenden mechanischen Stabilität hat das Abschirmelement 110 zum Beispiel eine Dicke von ca. 1 mm, jedoch kann das Abschirmelement 110 auch eine wesentlich geringere Dicke haben. Die abschirmende Funktion des Abschirmelements 110 kann zum Beispiel auch durch eine Abschirmfolie erreicht werden. Eine Abschirmfolie kann zum Beispiel auf das Spulengehäuseelement 28 aufgeklebt sein.

Für die Funktion des Abschirmelements 110 ist von Vorteil, wenn das Abschirmelement 110 eine möglichst große Ausdehnung in der Fläche, bezogen auf die von der Induktionsspule 18 umfasste Fläche, aufweist. Das Abschirmelement 110 weist eine Ausdehnung in der Fläche auf, welche mindestens im Wesentlichen der Fläche entspricht, die von der Induktionsspule 18 gebildet wird. Das im Wesentlichen kreisförmige Abschirmelement 110 hat einen Außendurchmesser, der mindestens so groß ist wie der Außendurchmesser der Induktionsspule 18. In einer alternativen Ausführungsform, in der die Induktionsspule 18 nicht kreisförmig, sondern zum Beispiel oval, rechteckig oder quadratisch, ausgebildet ist, ist die geometrische Grundform des Abschirmelements 110 vorteilhaft an die Grundform der Induktionsspule 18 angepasst. Dabei ist eine Projektionsfläche des Abschirmelements 110, die bei einer Projektion des Abschirmelements 110 entlang der Axialrichtung 46 gebildet wird, mindestens so groß wie die Projektionsfläche der Induktionsspule 18, die bei einer Projektion der Induktionsspule 18 entlang der Axialrichtung 46 gebildet wird.

## Patentansprüche

1. Induktionsladevorrichtung, insbesondere Handwerkzeuginduktionsladevorrichtung, mit einem Gehäuse (34), einem Aufnahmebereich (22) zur Aufnahme eines Induktionsakkumulators (14), einer Spuleneinheit (12), die zumindest ein Kernelement (16) und zumindest eine Induktionsspule (18), die das zumindest eine Kernelement (16) zumindest teilweise umschließt, umfasst, und zumindest einem Spulengehäuseelement (30), weiches in dem Gehäuse (34) zumindest die Spuleneinheit (12) relativ zu dem Aufnahmebereich (22) anordnet, **dadurch gekennzeichnet, dass** die Spuleneinheit (12) mehrere, insbesondere formgleiche, Kernelemente (16) aufweist und mehrere, insbesondere formgleiche, Federelemente (20) vorgesehen sind, welche jeweils eines der Kernelemente (16) zumindest teilweise zu der zumindest einen Induktionsspule (18) hin mit einer Kraft beaufschlagen.

2. Induktionsladevorrichtung nach Anspruch 1, **dadurch gekennzeichnet, dass** das Spulengehäuseelement (30) zumindest eine Ausnehmung (31) zur Aufnahme der zumindest einen Induktionsspule (18) aufweist.

3. Induktionsladevorrichtung nach einem der Ansprüche 1 oder 2, **dadurch gekennzeichnet, dass** das Spulengehäuseelement (30) zumindest einen Aufnahmebereich (33) zur Aufnahme des zumindest einen Kernelements (16) aufweist.

4. Induktionsladevorrichtung nach einem der vorhergehenden Ansprüche, **dadurch gekennzeichnet, dass** das Spulengehäuseelement (30) zumindest ein Halteelement (58) zur lösbaren Befestigung mit dem Gehäuse (34) aufweist.

5. Induktionsladevorrichtung nach einem der vorhergehenden Ansprüche, **gekennzeichnet durch** ein zweites Spulengehäuseelement (28), welches mit dem ersten Spulengehäuseelement (30) eine Spulengehäuseeinheit (24) bildet.

6. Induktionsladevorrichtung nach Anspruch 5, **dadurch gekennzeichnet, dass** die Spulengehäuseeinheit (24) zumindest ein Verbindungselement (32, 50) umfasst, welches die zwei Spulengehäuseelemente (28, 30) in einem montierten Zustand lösbar miteinander verbindet.

7. Induktionsladevorrichtung nach Anspruch 6, **dadurch gekennzeichnet, dass** das Verbindungselement als Rastelement (32, 50) ausgebildet ist.

8. Induktionsladevorrichtung nach Anspruch 1, **dadurch gekennzeichnet, dass** das zumindest eine Federelement (20) eine Kraft in Richtung des Aufnahmebereichs (22) auf das zumindest eine Kernelement (16) bewirkt.

9. Induktionsladevorrichtung nach einem der Ansprüche 1 oder 8, **dadurch gekennzeichnet, dass** das zumindest eine Federelement (20) und zumindest eines der zumindest zwei Spulengehäuseelemente (28, 30) derart zusammenwirken, dass das zumindest eine Kernelement (16) zu der zumindest einen Induktionsspule (18) hin vorgespannt ist.

10. Induktionsladevorrichtung nach einem der Ansprüche 1, 8 oder 9, **dadurch gekennzeichnet, dass** das zumindest eine Federelement (20) fest mit zumindest einem der Spulengehäuseelemente (28, 30) verbunden ist.

11. Induktionsladevorrichtung nach einem der Ansprüche 1, oder 8 bis 10, **dadurch gekennzeichnet, dass** das zumindest eine Federelement (20) mit zumindest einem der Spulengehäuseelemente (28, 30) einstückig ausgebildet ist.

12. Induktionsladevorrichtung nach einem der vorhergehenden Ansprüche, **dadurch gekennzeichnet, dass** die zumindest eine Induktionsspule (18) zumindest zwei Spulenanschlüsse (26) umfasst, die beabstandet zueinander angeordnet sind.

13. Induktionsladevorrichtung nach einem der vorhergehenden Ansprüche, **dadurch gekennzeichnet, dass** ein Abschirmelement (90) vorgesehen ist, welches dazu ausgebildet ist, elektromagnetische Störungen zu verringern.

14. Induktionsladevorrichtung nach Anspruch 13, **dadurch gekennzeichnet, dass** das Abschirmelement (90) zwischen dem Aufnahmebereich (22) und der Induktionsspule (18) angeordnet ist.

15. Induktionsladevorrichtung nach Anspruch 13, **dadurch gekennzeichnet, dass** das Abschirmelement (90) zwischen dem Aufnahmebereich (22) und dem Spulengehäuseelement (30) angeordnet ist.

16. Induktionsladevorrichtung nach einem der vorhergehenden Ansprüche, **dadurch gekennzeichnet, dass** ein weiteres Abschirmelement (110) vorgesehen ist, welches dazu ausgebildet ist, elektromagnetische Störungen zu verringern.

17. Induktionsladevorrichtung nach Anspruch 16, **dadurch gekennzeichnet, dass** das Abschirmelement (110) zwischen dem Gehäuseelement (72) und der Induktionsspule (18) angeordnet ist.

18. Induktionsladevorrichtung nach Anspruch 16, **dadurch gekennzeichnet, dass** das Abschirmelement (110) zwischen dem Gehäuseelement (72) und dem Spulengehäuseelement (28) angeordnet ist.

19. System mit einer Induktionsladevorrichtung (10) nach einem der vorhergehenden Ansprüche und mit zumindest einem Induktionsakkumulator (14), insbesondere mit einem Handwerkzeuginduktionsakkumulator.

## Claims

1. Induction charging apparatus, in particular handheld tool induction charging apparatus, comprising a housing (34), a receiving region (22) for receiving an induction accumulator (14), a coil unit (12) which comprises at least one core element (16) and at least one induction coil (18) which at least partially surrounds the at least one core element (16), and at least one coil housing element (30) which arranges at least the coil unit (12) relative to the receiving region (22) in the housing (34), **characterized in that** the coil unit (12) has a plurality of, in particular dimensionally identical, core elements (16), and a plurality of, in particular dimensionally identical, spring elements (20) are provided which each apply a force to one of the core elements (16) at least partially towards the at least one induction coil (18).

2. Induction charging apparatus according to Claim 1, **characterized in that** the coil housing element (30) has at least one recess (31) for receiving the at least one induction coil (18).

3. Induction charging apparatus according to either of Claims 1 and 2, **characterized in that** the coil housing element (30) has at least one receiving region (33) for receiving the at least one core element (16).

4. Induction charging apparatus according to one of the preceding claims, **characterized in that** the coil housing element (30) has at least one holding element (58) for releasable fastening to the housing (34).

5. Induction charging apparatus according to one of the preceding claims, **characterized by** a second coil housing element (28) which, with the first coil housing element (30), forms a coil housing unit (24).

6. Induction charging apparatus according to Claim 5, **characterized in that** the coil housing unit (24) comprises at least one connecting element (32, 50) which releasably connects the two coil housing elements (28, 30) to one another in a mounted state.

7. Induction charging apparatus according to Claim 6, **characterized in that** the connecting element is designed as a latching element (32, 50).

8. Induction charging apparatus according to Claim 1, **characterized in that** the at least one spring element (20) applies a force onto the at least one core element (16) in the direction of the receiving region (22).

9. Induction charging apparatus according to either of Claims 1 and 8, **characterized in that** the at least one spring element (20) and at least one of the at least two coil housing elements (28, 30) interact in such a way that the at least one core element (16) is prestressed towards the at least one induction coil (18).

10. Induction charging apparatus according to one of Claims 1, 8 and 9, **characterized in that** the at least one spring element (20) is fixedly connected to at least one of the coil housing elements (28, 30).

11. Induction charging apparatus according to one of Claims 1 and 8 to 10, **characterized in that** the at least one spring element (20) is integrally formed with at least one of the coil housing elements (28, 30).

12. Induction charging apparatus according to one of the preceding claims, **characterized in that** the at least one induction coil (18) comprises at least two coil connections (26) which are arranged at a distance from one another.

13. Induction charging apparatus according to one of the preceding claims, **characterized in that** a shielding element (90) is provided which is designed to reduce electromagnetic interference.

14. Induction charging apparatus according to Claim 13, **characterized in that** the shielding element (90) is arranged between the receiving region (22) and the induction coil (18).

15. Induction charging apparatus according to Claim 13, **characterized in that** the shielding element (90) is arranged between the receiving region (22) and the coil housing element (30).

16. Induction charging apparatus according to one of the preceding claims, **characterized in that** a further shielding element (110) is provided which is designed to reduce electromagnetic interference.

17. Induction charging apparatus according to Claim 16, **characterized in that** the shielding element (110) is arranged between the housing element (72) and the induction coil (18).

18. Induction charging apparatus according to Claim 16, **characterized in that** the shielding element (110) is arranged between the housing element (72) and the coil housing element (28).

19. System comprising an induction charging apparatus (10) according to one of the preceding claims and comprising at least one induction accumulator (14), in particular comprising a handheld tool induction accumulator.

## Revendications

1. Dispositif de charge par induction, en particulier dispositif de charge par induction d'un outil à main, comportant un boîtier (34), une zone de réception (22) destinée à recevoir un accumulateur à induction (14), une unité formant bobine (12) qui comporte au moins un élément formant noyau (16) et au moins une bobine d'induction (18) qui entoure au moins partiellement l'au moins un élément formant noyau (16), et au moins un élément de boîtier de bobine (30) qui dispose au moins l'unité formant bobine (12) dans le boîtier (34) par rapport à la zone de réception (22), **caractérisé en ce que** l'unité formant bobine (12) comporte une pluralité d'éléments formant noyaux (16), en particulier de même forme, et une pluralité d'éléments élastiques (20), en particulier de même forme, sont prévus, lesquels soumettent chacun un des éléments formant noyaux (16) à une force au moins en partie en direction de l'au moins une bobine d'induction (18).

2. Dispositif de charge par induction selon la revendication 1, **caractérisé en ce que** l'élément de boîtier de bobine (30) comporte au moins un évidement (31) destiné à recevoir l'au moins une bobine d'induction (18).

3. Dispositif de charge par induction selon l'une des revendications 1 ou 2, **caractérisé en ce que** l'élément de boîtier de bobine (30) comporte au moins une zone de réception (33) destinée à recevoir l'au moins un élément formant noyau (16).

4. Dispositif de charge par induction selon l'une des revendications précédentes, **caractérisé en ce que** l'élément de boîtier de bobine (30) comporte au moins un élément de retenue (58) destiné à la fixation amovible au boîtier (34).

5. Dispositif de charge par induction selon l'une des revendications précédentes, **caractérisé par** un deuxième élément de boîtier de bobine (28) qui forme avec le premier élément de boîtier de bobine (30) une unité de boîtier de bobine (24).

6. Dispositif de charge par induction selon la revendication 5, **caractérisé en ce que** l'unité de boîtier de bobine (24) comprend au moins un élément de liaison (32, 50) qui relie entre eux de manière amovible les deux éléments de boîtier de bobine (28, 30) une fois montés.

7. Dispositif de charge par induction selon la revendication 6, **caractérisé en ce que** l'élément de liaison est conçu comme un élément à encliquetage (32, 50) .

8. Dispositif de charge par induction selon la revendication 1, **caractérisé en ce que** l'au moins un élément élastique (20) exerce une force en direction de la zone de réception (22) sur l'au moins un élément formant noyau (16).

9. Dispositif de charge par induction selon l'une des revendications 1 ou 8, **caractérisé en ce que** l'au moins un élément élastique (20) et l'un au moins des au moins deux éléments de boîtier de bobine (28, 30) coopèrent de telle sorte que l'au moins un élément formant noyau (16) est précontraint vers l'au moins une bobine d'induction (18).

10. Dispositif de charge par induction selon l'une des revendications 1, 8 ou 9, **caractérisé en ce que** l'au moins un élément élastique (20) est fixé à l'un au moins des éléments de boîtier de bobine (28, 30).

11. Dispositif de charge par induction selon l'une des revendications 1, ou 8 à 10, **caractérisé en ce que** l'au moins un élément élastique (20) est conçu d'une seule pièce avec au moins un des éléments de boîtier de bobine (28, 30).

12. Dispositif de charge par induction selon l'une des revendications précédentes, **caractérisé en ce que** l'au moins une bobine d'induction (18) comprend au moins deux bornes de bobine (26) qui sont espacées l'une de l'autre.

13. Dispositif de charge par induction selon l'une des revendications précédentes, **caractérisé en ce qu'**un élément de blindage (90) est prévu, lequel est conçu pour réduire les interférences électromagnétiques.

14. Dispositif de charge par induction selon la revendication 13, **caractérisé en ce que** l'élément de blindage (90) est disposé entre la zone de réception (22) et la bobine d'induction (18).

15. Dispositif de charge par induction selon la revendication 13, **caractérisé en ce que** l'élément de blindage (90) est disposé entre la zone de réception (22) et l'élément de boîtier de bobine (30).

16. Dispositif de charge par induction selon l'une des revendications précédentes, **caractérisé en ce qu'**un autre élément de blindage (110) est prévu, lequel est conçu pour réduire les interférences électromagnétiques.

17. Dispositif de charge par induction selon la revendication 16, **caractérisé en ce que** l'élément de blindage (110) est disposé entre l'élément de boîtier (72) et la bobine d'induction (18).

18. Dispositif de charge par induction selon la revendication 16, **caractérisé en ce que** l'élément de blindage (110) est disposé entre l'élément de boîtier (72) et l'élément de boîtier de bobine (28).

19. Système pourvu d'un dispositif de charge par induction (10) selon l'une des revendications précédentes et d'au moins un accumulateur à induction (14), en particulier un accumulateur à induction d'un outil à main.
